# EUROPEAN PATENT APPLICATION

(11) **EP 4 692 941 A2**
(43) Date of publication of application: **11.02.2026**
(21) Application number: 25189794.8
(22) Date of filing: 16.07.2025
(51) Int. Cl.: G03F 7/075

(54) **COMPOSITION FOR FORMING SILICON-CONTAINING RESIST FILM AND PATTERNING PROCESS**

(30) Priority: 07.08.2024 JP 2024131082
(71) Applicant: Shin-Etsu Chemical Co., Ltd., Tokyo 100-0005 (JP)
(72) Inventor: Sawamura, Takashi, Niigata (JP); Mashita, Takato, Niigata (JP); Mitsui, Ryo, Niigata (JP)
(74) Representative: Schicker, Silvia

(57) **Abstract**

The present invention is a composition for forming a silicon-containing resist film contains a polysiloxane containing at least one of any of a repeating unit represented by formula (A-1), a repeating unit represented by formula (A-2), or a substructure represented by formula (A-3): 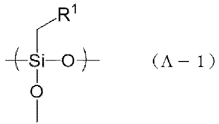 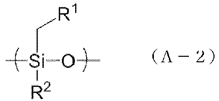 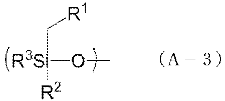 wherein R¹ is a monovalent organic group, a halogen atom, a hydroxy group, a sulfo group, a nitro group, or a carboxyl group, functioning as a group eliminated by heat, acid, or base, and R² and R³ represent a monovalent organic group. The present invention can provide a composition for forming a silicon-containing resist film such that an ultra-fine resist pattern with excellent LWR (line width roughness) and CDU (critical dimension uniformity) can be formed.

## Description

### TECHNICAL FIELD

The present invention relates to a composition for forming a silicon-containing resist film and a patterning process using the composition.

### BACKGROUND ART

As large-scale integrated circuits (LSIs) become more highly integrated and faster, pattern dimensions are rapidly miniaturized. In line with this miniaturization, lithography technology has achieved the formation of fine patterns by using shorter wavelengths of light sources and appropriate selection of corresponding resist compositions. At the center of this effort was a positive photoresist composition used in a single layer. In this single-layer positive photoresist composition, the resist resin has a backbone that is etching-resistant against dry etching using chlorine- or fluorine-based gas plasma, and has a switching mechanism, by which the exposed area is dissolved, thereby dissolving the exposed area and forming a pattern. The remaining resist pattern is used as an etching mask for the process of dry-etching a substrate to be processed.

However, when the thickness of the photoresist film used is kept the same during miniaturization (i.e., while the pattern width is made smaller), the resolution performance of the photoresist film deteriorates, and when the photoresist film is pattern-developed with a developing solution, the so-called aspect ratio becomes too large, resulting in pattern collapse, which is problematic. For this reason, photoresist films have become thinner as patterns have become finer.

On the other hand, a substrate to be processed is usually processed by a dry etching method using a patterned photoresist film as an etching mask during processing of the substrate. However, in reality, there is no dry etching method that can achieve perfect etching selectivity between the photoresist film and the substrate to be processed. Therefore, a problem has been that the resist film was also damaged and collapsed during substrate processing, and the resist pattern could not be accurately transferred to the substrate to be processed. Therefore, as patterns become finer, higher dry etching resistance has been required for photoresist compositions. By contrast, however, in order to improve resolution, resins with small optical absorption at the exposure wavelength have been sought for resins used in photoresist compositions. Therefore, as the wavelength of the exposure light became shorter and shorter, from i-line to KrF and ArF, the resins used in the photoresist composition also changed to novolac resins, polyhydroxystyrene, and resins with aliphatic polycyclic skeletons. However, in reality, the etching rate under dry etching conditions during substrate processing has become fast. Recent photoresist compositions with high resolution tended to be rather weak in etching resistance.

This means that the substrate to be processed should be dry-etched with a thinner and less etch-resistant photoresist film. Securing materials and processes for this processing step has become an urgent need.

One of the methods to solve these problems is the multilayer resist method. In this method, a resist middle layer film with etching selectivity different from a photoresist film (i.e., a resist upper layer film) is interposed between the resist upper layer film and a substrate to be processed, and the resist upper layer film is patterned; then, using the resist upper layer film pattern as a dry etching mask, the pattern is transferred to the resist middle layer film by dry etching; and the resist middle layer film is used as a dry etching mask, and the pattern is transferred to the substrate to be processed by dry etching.

One of the multilayer resist methods is the three-layer resist method, which can be implemented using a common resist composition used in the single-layer resist method. In this three-layer resist method, for example, an organic film made of novolac resin or the like is deposited on a substrate to be processed, a silicon-containing resist middle layer film is deposited on top of the organic film, and an ordinary organic photoresist film is formed thereon as the resist upper layer film. At the time of dry etching with fluorine-based gas plasma, the organic resist upper layer film has a good etching selectivity ratio to the silicon-containing resist middle layer film. Thus, the resist upper layer film pattern can be transferred to the silicon-containing resist middle layer film by dry etching with fluorine-based gas plasma. This method enables a pattern to be transferred onto the silicon-containing resist middle layer film even when using a resist composition that is difficult to form a pattern with sufficient film thickness to directly process the substrate to be processed or a resist composition that does not have sufficient dry etching resistance for processing the substrate. If the pattern is transferred by dry etching with oxygen- or hydrogen-based gas plasma subsequently, an organic film made of novolac resin or the like, which has sufficient dry etching resistance for processing the substrate, can be patterned. The silicon-containing resist middle layer film that remains after formation of the organic film pattern is generally removed by dry etching with fluorine-based gas plasma or wet etching with an alkaline or fluorine-based etchant to avoid defect-causing residues. If the etching rate is insufficient, there is a greater possibility to cause problems such that residues from the silicon-containing resist middle layer film will remain and become defects, or that a long etching process will be required and will damage the substrate to be processed. Thus, for accurate patterning and smooth removal, the silicon-containing resist middle layer film requires an appropriate etching rate.

Meanwhile, the advent of ArF immersion lithography, EUV lithography and the like in recent years has enabled finer patterns to be formed, and this has been accompanied by a trend toward thinner photoresist films. Such thinning of photoresist films leads to degradation of edge roughness (LWR) and hole pattern dimension uniformity (CDU) in ultrafine patterns. Therefore, improvement of LWR and CDU has become a serious issue.

Here, a composition for forming a silicon-containing resist film for ArF or EUV lithography, which composition contains a curing catalyst, has been proposed (Patent Documents 1 to 2). The curing catalyst has a structure suitable for catalyzing the condensation reaction of silanols and promoting the formation of siloxane linkage as the main backbone of the silicon-containing resist film. It is also becoming clear that the choice of curing catalyst has various effects on the properties of the silicon-containing resist film. Examples thereof include acidity/basicity, hydrophilicity/hydrophobicity, hardness, film density, and etching rate. Such a curing catalyst has a structure similar to that of a sensitivity modifier in the upper layer resist. As a result, the problem is that diffusion into the upper layer resist due to heating or light exposure greatly affect the patterning ability of the photoresist. In particular, since it affects the performance of LWR and CDU, it is necessary to develop a curing catalyst with reduced diffusion into the upper layer resist.

On the other hand, photosensitive upper layer resist materials have been known that contain a compound having a cation and an anion in the molecule to improve LWR and CDU (Patent Documents 3). However, in recent ultra-fine patterns, more precise LWR and CDU have been required, and the performance of the resist film needs to be improved as well.

### CITATION LIST

### PATENT LITERATURE

Patent Document 1: JP 2007-302873 A
Patent Document 2: WO2013/161372 A1
Patent Document 3: JP 2011-016746 A

### SUMMARY OF INVENTION

### TECHNICAL PROBLEM

The present invention has been made to solve the above problem, and the purpose of the present invention is to provide: a composition for forming a silicon-containing resist film such that a silicon-containing resist film can be formed to have an appropriate etching rate and improve LWR and CDU in an ultra-fine pattern in a multilayer resist method; and a patterning process using the composition.

### SOLUTION TO PROBLEM

To solve the above problem, the present invention provides a composition for forming a silicon-containing resist film comprising a polysiloxane comprising at least one of any of a repeating unit represented by formula (A-1), a repeating unit represented by formula (A-2), or a substructure represented by formula (A-3): 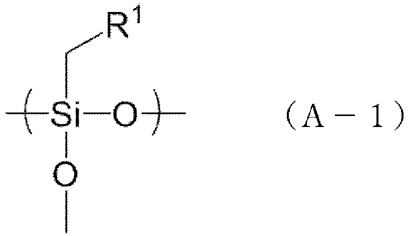 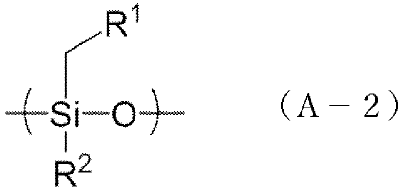 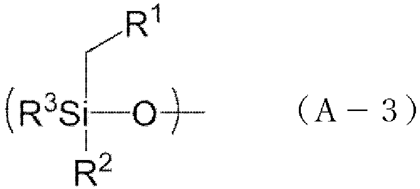 wherein R¹ is a monovalent organic group having 1 to 30 carbon atoms and optionally having a substituent, a halogen atom, a hydroxy group, a sulfo group, a nitro group, or a carboxyl group, functioning as a group eliminated by heat, acid, or base, and R² and R³ each independently represent a monovalent organic group having 1 to 30 carbon atoms and optionally having a substituent.

Since the side chains of the polysiloxane structure with such repeating units and substructure undergo an elimination reaction caused by heat, acid, or base, a silicon-containing resist film with a high ratio of silicon atoms can be formed and has favorable LWR and CDU properties. Further, the effect of silicon atoms enables the formation of a resist film with a good etching rate.

In addition, in the present invention, R¹ in the formula (A-1), (A-2), or (A-3) is a monovalent group represented by formula (B-1), a halogen atom, a hydroxy group, a sulfo group, a nitro group, or a carboxyl group, functioning as a group eliminated by heat, acid, or base, 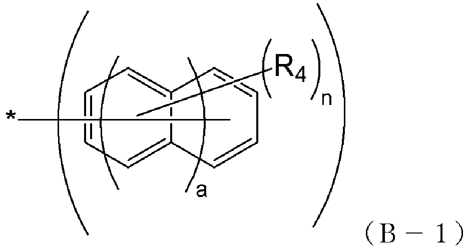 wherein R₄ are each a substituent attached to an aromatic ring and each independently represent a hydrogen atom or an alkyl group having 1 to 20 carbon atoms and optionally having a substituent, an aryl group having 6 to 20 carbon atoms and optionally having a substituent, a halogenated alkyl group having 1 to 20 carbon atoms and optionally having a substituent, a halogenated aryl group having 6 to 20 carbon atoms and optionally having a substituent, an alkoxyalkyl group having 1 to 20 carbon atoms and optionally having a substituent, an alkoxyaryl group having 6 to 20 carbon atoms and optionally having a substituent, an acyl group having 6 to 20 carbon atoms and optionally having a substituent, a halogen atom, a hydroxy group, a sulfo group, a nitro group, or a carboxyl group; a = 0 or 1; n = 2a + 5; and * denotes a bond to another atom.

Since the side chains of the polysiloxane structure with such repeating units and substructure more likely undergo an elimination reaction caused by heat, acid, or base, a silicon-containing resist film with a high ratio of silicon atoms can be more favorably formed and has better LWR and CDU properties. Further, a resist film with a much better etching rate can be formed.

In the present invention, the polysiloxane preferably further comprises a thermally crosslinkable polysiloxane comprising at least one of any of a repeating unit represented by formula (Sx-1), a repeating unit represented by formula (Sx-2), or a substructure represented by formula (Sx-3): 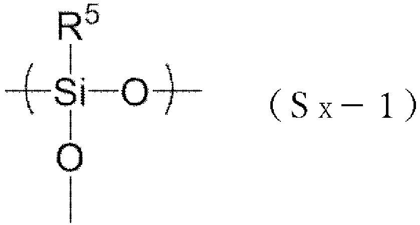 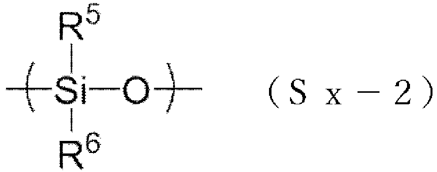 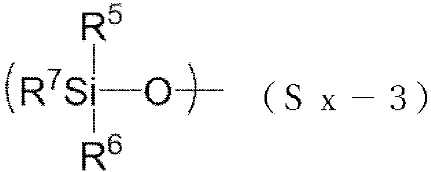 wherein R⁵, R⁶, and R⁷ are each independently a monovalent organic group having 1 to 30 carbon atoms and optionally having a substituent.

If the above thermally crosslinkable polysiloxane contains the above specific structure, adhesion to the resist is high and the effect of the present invention is more fully produced.

The composition for forming a silicon-containing resist film according to the present invention preferably further comprises a crosslinking catalyst.

With such a composition for forming a silicon-containing resist film, the cross-linking reaction proceeds sufficiently and the etching resistance of the resist film derived from the composition for forming a silicon-containing resist film according to the present invention is favorable.

In the composition for forming a silicon-containing resist film according to the present invention, the crosslinking catalyst is preferably an ammonium salt or a sulfonium salt.

With such a composition for forming a silicon-containing resist film, the etching resistance of the resist film derived from the composition for forming a silicon-containing resist film according to the present invention is better.

The composition for forming a silicon-containing resist film according to the present invention preferably further comprises an acid generator.

By adding an acid generator as necessary, the pattern shape, exposure sensitivity, etc., can be fine-tuned.

In the composition for forming a silicon-containing resist film according to the present invention, the crosslinking catalyst is preferably a sulfonium salt.

With such a composition for forming a silicon-containing resist film, it is possible to moderately adjust the pattern shape, exposure sensitivity, etc., of the resist film while minimizing the degradation of other performances, and in addition, it is effective in decreasing the residue derived from the resist film.

In addition, the present invention provides a patterning process comprising the steps of:
forming, on a body to be processed, an organic film using a coating-type organic film material;
forming, on the organic film, a silicon-containing resist middle layer film using the above composition for forming a silicon-containing resist film;
forming, on the silicon-containing resist middle layer film, a resist upper layer film by using a resist upper layer film material comprising a photoresist composition;
forming a circuit pattern on the resist upper layer film;
using, as a mask, the resist upper layer film having the formed circuit pattern to transfer the pattern onto the silicon-containing resist middle layer film by etching;
using, as a mask, the silicon-containing resist middle layer film having the transferred pattern to transfer the pattern onto the organic film by etching; and
using, as a mask, the organic film having the transferred pattern to transfer the pattern onto the body to be processed by etching.

Further, the present invention provides a patterning process comprising the steps of:
forming, on a body to be processed by CVD method, a hard mask primarily composed of carbon;
forming, on the hard mask, a silicon-containing resist middle layer film using the above composition for forming a silicon-containing resist film;
forming, on the silicon-containing resist middle layer film, a resist upper layer film by using a resist upper layer film material comprising a photoresist composition;
forming a circuit pattern on the resist upper layer film;
using, as a mask, the resist upper layer film having the formed circuit pattern to transfer the pattern onto the silicon-containing resist middle layer film by etching;
using, as a mask, the silicon-containing resist middle layer film having the transferred pattern to transfer the pattern onto the hard mask by dry etching; and
using, as a mask, the hard mask having the transferred pattern to transfer the pattern onto the body to be processed by dry etching.

The above patterning process is particularly practical for forming fine patterns because it suppresses pattern collapse of the resist upper layer film and excels in pattern transfer to the silicon-containing resist middle layer film by dry etching, and because the silicon-containing resist middle layer film remaining after the patterning is finished is easily removed and defects due to residues are hardly generated.

Furthermore, the present invention provides the patterning process, wherein the pattern formation in the step of forming a circuit pattern on the resist upper layer film is pattern formation performed by optical lithography with a wavelength of 10 nm or more and 300 nm or less, direct electron beam lithography, nanoimprinting, or a combination thereof.

Such a method of forming a circuit pattern on the resist upper layer film will more fully produce the effects of the present invention.

Also, in the present invention, the body to be processed is preferably any of a semiconductor device substrate, a metal film, a metal carbide film, a metal oxide film, a metal nitride film, a metal oxide carbide film, or a metal oxide nitride film.

When the above specific material is used as the body to be processed above, the effect of the present invention is more fully produced.

Moreover, in the present invention, a metal constituting the body to be processed is preferably silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

When the above specific metal is used as the metal constituting the body to be processed above, the effect of the present invention is more fully produced.

### ADVANTAGEOUS EFFECTS OF INVENTION

As described above, the polysiloxane with the repeating units and substructure in the present invention shows high solubility and stability in organic solvents, while a heat or acid-induced elimination reaction occurs during curing. This can provide a film with a high silicon ratio, which not only enables formation of an ultra-fine upper layer resist pattern with good LWR and CDU, but also provides excellent dry etching selectivity between the resist film and an organic film or hard mask. Therefore, patterns for semiconductor devices can be formed on substrates with high yield. In addition, the formed silicon-containing resist middle layer film has high etching selectivity with organic materials. Therefore, the formed photoresist pattern can be transferred to a silicon-containing resist middle layer film, organic film, or hard mask sequentially while using a dry etching process. Further, since the formed silicon-containing resist middle layer film has a sufficient etching rate, it is easy to remove the remaining silicon-containing resist middle layer film after the patterning is finished, and defects due to residues are unlikely to occur. Therefore, it is especially useful for the formation of fine patterns.

### DESCRIPTION OF EMBODIMENTS

Hereinafter, the present invention will be described in more detail. As described above, development has been sought to provide: a composition for forming a silicon-containing resist film such that a silicon-containing resist film can be formed to have an appropriate etching rate and improve LWR and CDU in an ultra-fine pattern in a multilayer resist method; and a patterning process using the composition.

The present inventors have conducted intensive research to achieve the above-mentioned purpose, and, as a result, have found that by adding a polysiloxane containing specific repeating units and/or substructure in the composition for forming a silicon-containing resist film, LWR and CDU of ultrafine patterns are improved in the multilayer resist method, and a silicon-containing resist film with an etching rate suitable for processing is thus provided. The present invention has then been completed.

Specifically, the present invention is a composition for forming a silicon-containing resist film, comprising a polysiloxane comprising at least one of any of a repeating unit represented by formula (A-1), a repeating unit represented by formula (A-2), or a substructure represented by formula (A-3): 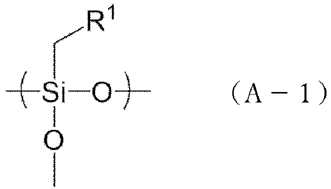 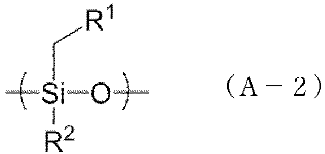 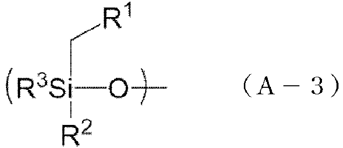 wherein R¹ is a monovalent organic group having 1 to 30 carbon atoms and optionally having a substituent, a halogen atom, a hydroxy group, a sulfo group, a nitro group, or a carboxyl group, functioning as a group eliminated by heat, acid, or base, and R² and R³ each independently represent a monovalent organic group having 1 to 30 carbon atoms and optionally having a substituent.

Hereinbelow, the present invention will be described specifically. However, the present invention is not limited thereto.

### <Composition for forming silicon-containing resist film>

The composition for forming a silicon-containing resist film according to the present invention is a composition for forming a silicon-containing resist film, comprising at least one of any of the above repeating unit represented by general formula (A-1) or (A-2) or the above substructure represented by general formula (A-3). In addition to these, any other component(s) may also be included.

The following details each component included in the composition for forming a silicon-containing resist film according to the present invention.

### [Thermally crosslinkable polysiloxane (Sx)]

The composition for forming a silicon-containing resist film according to the present invention may include a thermally crosslinkable polysiloxane (Sx) comprising at least one of any of the above repeating unit represented by general formula (A-1) or (A-2) or the above substructure represented by general formula (A-3).

In the repeating units and substructure represented by the above formulae (A-1), (A-2), and (A-3), examples of R¹ include, but are not limited to, the following structures.

Specific examples of R¹ include a methyl group, an ethyl group, a vinyl group, a propyl group, an isopropyl group, an allyl group, a butyl group, an isobutyl group, a *sec*-butyl group, a t-butyl group, a pentyl group, an isopentyl group, a sec-pentyl group, a 3-pentyl group, a t-pentyl group, a neopentyl group, a cyclopropyl group, a cyclobutyl group, a cyclopentyl group, a cyclohexyl group, a phenyl group, a tolyl group, an ethylphenyl group, a propylphenyl group, an isopropylphenyl group, a fluorophenyl group, a chlorophenyl group, a bromophenyl group, an iodophenyl group, a methoxyphenyl group, an ethoxyphenyl group, a propoxyphenyl group, an isopropoxyphenyl group, a butoxyphenyl group, an isobutoxyphenyl group, a sec-butoxyphenyl group, a t-butoxyphenyl group, a pentoxyphenyl group, an isopentoxyphenyl group, a sec-pentoxyphenyl group, a 3-pentoxyphenyl group, a t-pentoxyphenyl group, a neopentoxyphenyl group, an acetylphenyl group, a hydroxyphenyl group, a sulfophenyl group, a nitrophenyl group, a naphthyl group, a methylnaphthyl group, an ethylnaphthyl group, a propylnaphthyl group, an isopropylnaphthyl group, a fluoronaphthyl group, a chloronaphthyl group, a bromonaphthyl group, an iodonaphthyl group, a methoxynaphthyl group, an ethoxynaphthyl group, a propoxynaphthyl group, an isopropoxynaphthyl group, a butoxynaphthyl group, an isobutoxynaphthyl group, a sec-butoxynaphthyl group, a t-butoxynaphthyl group, a pentoxynaphthyl group, an isopentoxynaphthyl group, a sec-pentoxynaphthyl group, a 3-pentoxynaphthyl group, a t-pentoxynaphthyl group, a neopentoxynaphthyl group, an acetylnaphthyl group, a hydroxynaphthyl group, a sulfonaphthyl group, a nitronaphthyl group, a methoxy group, an ethoxy group, a propoxy group, an isopropoxy group, a butoxy group, an isobutoxy group, a sec-butoxy group, a t-butoxy group, a pentoxy group, an isopentoxy group, a sec-pentoxy group, a 3-pentoxy group, a t-pentoxy group, a neopentoxy group, fluorine, chlorine, bromine, iodine, a hydroxy group, a sulfo group, a nitro group, and a carboxy group.

R² and R³ each independently represent a monovalent organic group having 1 to 30 carbon atoms and optionally having a substituent. R² and R³ are preferably a saturated or unsaturated organic group having 1 to 20 carbon atoms and optionally having a substituent. Examples of the organic group include a substituted or unsubstituted chained, branched, or cyclic alkyl group having 1 to 20 carbon atoms, a substituted or unsubstituted chained, branched, or cyclic alkenyl group having 2 to 20 carbon atoms, and a substituted or unsubstituted aryl group having 6 to 20 carbon atoms. Specific examples thereof include a methyl group, an ethyl group, an n-propyl group, an i-propyl group, an n-butyl group, an i-butyl group, a *sec*-butyl group, a t-butyl group, an n-pentyl group, an n-hexyl group; a vinyl group, an allyl group, a propenyl group; a phenyl group, and a tolyl group.

In the composition for forming a silicon-containing resist film according to the present invention, R¹ in the formula (A-1), (A-2), or (A-3) is preferably a monovalent group represented by formula (B-1), a halogen atom, a hydroxy group, a sulfo group, a nitro group, or a carboxyl group, functioning as a group eliminated by heat, acid, or base, 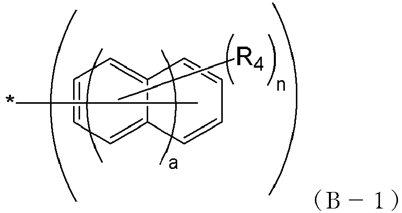 wherein R₄ are each a substituent attached to an aromatic ring and each independently represent a hydrogen atom or an alkyl group having 1 to 20 carbon atoms and optionally having a substituent, an aryl group having 6 to 20 carbon atoms and optionally having a substituent, a halogenated alkyl group having 1 to 20 carbon atoms and optionally having a substituent, a halogenated aryl group having 6 to 20 carbon atoms and optionally having a substituent, an alkoxyalkyl group having 1 to 20 carbon atoms and optionally having a substituent, an alkoxyaryl group having 6 to 20 carbon atoms and optionally having a substituent, an acyl group having 6 to 20 carbon atoms and optionally having a substituent, a halogen atom, a hydroxy group, a sulfo group, a nitro group, or a carboxyl group; a = 0 or 1; n = 2a + 5; and * denotes a bond to another atom.

Since the side chains of the polysiloxane structure with such a substructure more likely undergo an elimination reaction caused by heat, acid, or base, a silicon-containing resist film with a high ratio of silicon atoms can be more favorably formed and has better LWR and CDU properties. Further, a resist film with a much better etching rate can be formed.

Specific examples of R₄ include a methyl group, an ethyl group, an n-propyl group, an i-propyl group, an n-butyl group, an i-butyl group, a *sec*-butyl group, a t-butyl group, an n-pentyl group, an n-hexyl group; a vinyl group, an allyl group, a propenyl group; a phenyl group, a tolyl group; a trifluoromethyl group, a trichloromethyl group; a methoxy group, an ethoxy group, an n-propoxy group, an i-propoxy group; a methoxymethyl group, an ethoxymethyl group; an m-chlorophenyl group; an acetyl group; and a chlorine atom, a bromine atom, an iodine atom, a hydroxy group, a sulfo group, a nitro group, and a carboxy group.

It is preferable that in (B-1), a is 0 or 1 and R₄ is a hydrogen atom or an alkyl group having 1 to 20 carbon atoms and optionally having a substituent or an alkoxy group having 1 to 20 carbon atoms and optionally having a substituent or a halogen atom.

The above polysiloxane preferably comprises a thermally crosslinkable polysiloxane comprising at least one of any of a repeating unit represented by formula (Sx-1), a repeating unit represented by formula (Sx-2), or a substructure represented by formula (Sx-3): 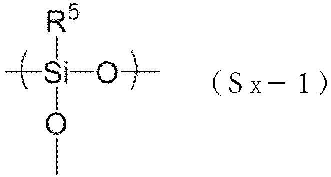 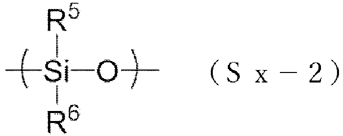 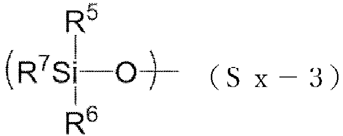 wherein R⁵, R⁶, and R⁷ are each a monovalent organic group having 1 to 30 carbon atoms and are same or different.

R⁵, R⁶, and R⁷ above are each a monovalent organic group having 1 to 30 carbon atoms and optionally having a substituent.

Specific examples of a group represented by R⁵, R⁶, or R⁷ include a linear, branched, or cyclic alkyl group having 1 to 12 carbon atoms and optionally having a substituent, an alkenyl group, a substituted or unsubstituted aryl group having 6 to 20 carbon atoms, and an aralkyl group having 7 to 12 carbon atoms.

Examples of R⁵, R⁶, and R⁷ include an organic group having one or more carbon-oxygen single bonds or carbon-oxygen double bonds. Specifically, the organic group has one or more groups selected from the group consisting of an ether bond, an ester bond, an alkoxy group, and a hydroxy group.

A specific example of the above include the one that is shown by formula (Sm-R):

(P-Q₁-(S₁)ᵥ₁-Q₂-)ᵤ-(T)ᵥ₂-Q₃-(S₂)ᵥ₃-Q₄-

(Sm-R)
wherein, P is a hydrogen atom, a cyclic ether group, a hydroxy group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ are each independently - CqH(2q-p)Pp- (where P is the same as above, p is an integer of 0 to 3, and q is an integer of 0 to 10 (provided that q = 0 indicates a single bond)); u is an integer of 0 to 3; S1 and S2 each independently represent -O-, -CO-, -OCO-, -COO-, or -OCOO-; v1, v2, and v3 each independently represent 0 or 1; T is a divalent group consisting of a divalent atom other than carbon, a fatty ring, an aromatic ring, or a heterocyclic ring; examples of an alicyclic, aromatic or heterocyclic ring optionally containing a heteroatom such as an oxygen atom as T are shown below; and the position of the bond to Q2 or Q3 at T is not particularly limited, but can be selected, if appropriate, in consideration of the reactivity due to steric factors and the availability of commercial reagents for the reaction, etc.

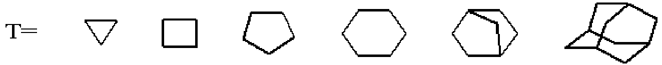

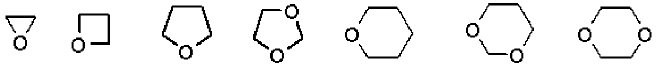

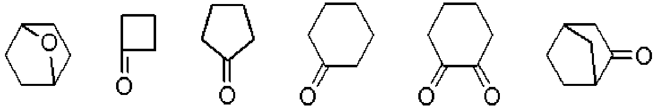

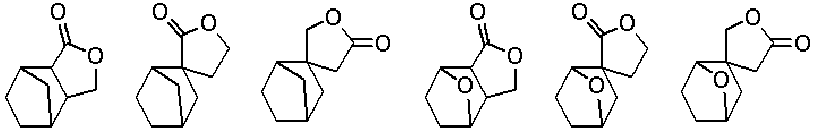

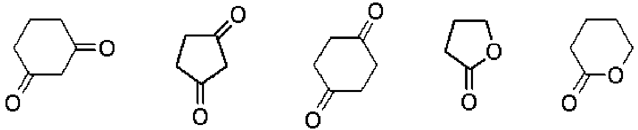

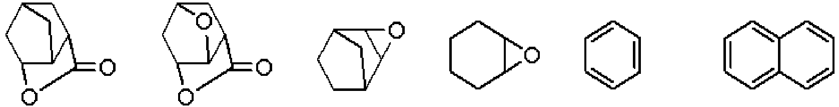

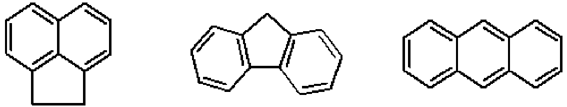

Preferred examples of the organic group having one or more carbon-oxygen single bonds or carbon-oxygen double bonds in the formula (Sm-R) include the following. Note that in the following formulae, (Si) is used to indicate the site of bonding to Si.

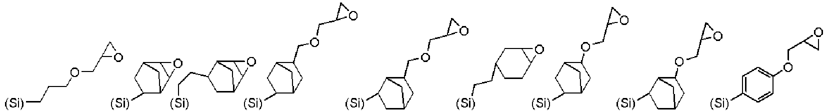

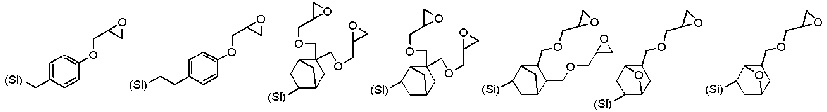

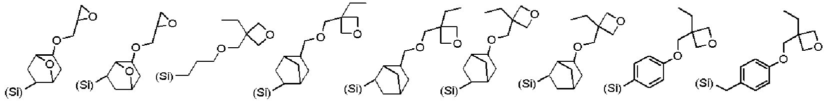

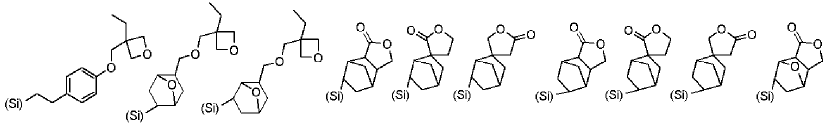

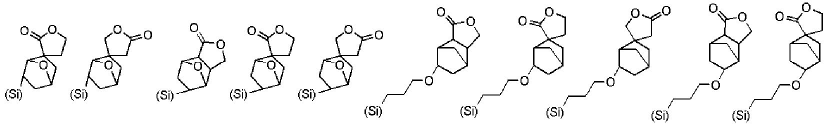

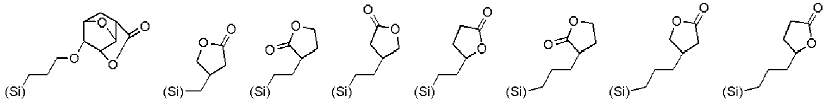

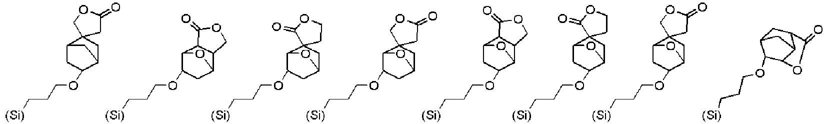

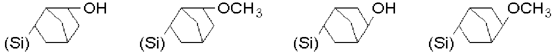

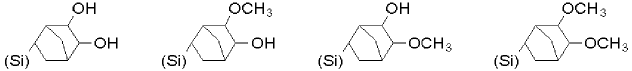

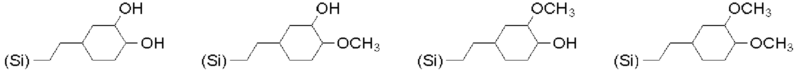

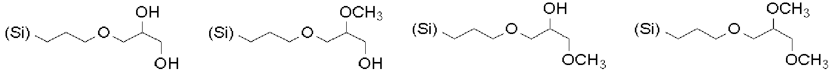

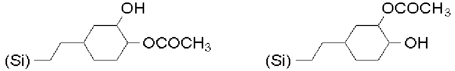

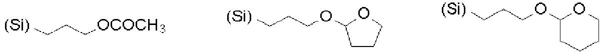

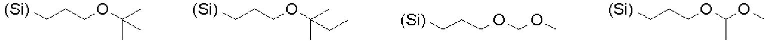

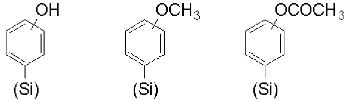

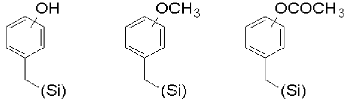

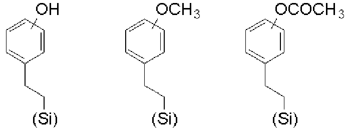

In addition, an organic group containing a silicon-silicon bond can also be used as an example of the organic group of R⁵, R⁶, or R⁷. Specific examples include the following.

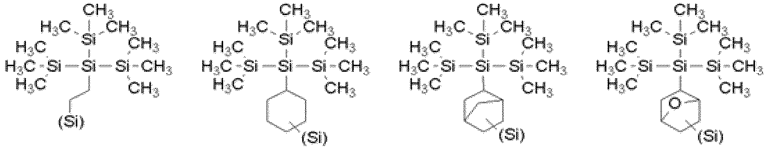

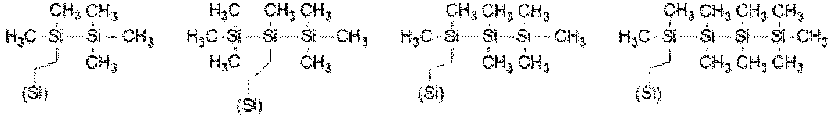

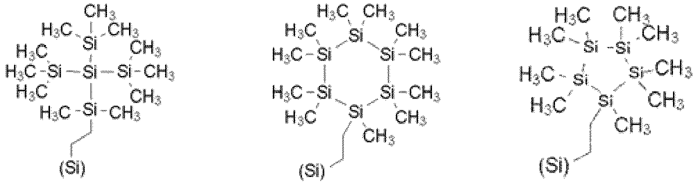

In addition, an organic group having a protecting group degraded by acid can also be used as an example of the organic group of R⁵, R⁶, or R⁷. Specific examples thereof include the organic groups listed in paragraphs [0043] to [0048] of JP 2013-167669 A, and the organic groups obtained from silicon compounds as shown in paragraph [0056] of JP 2013-224279 A.

Further, an organic group having a fluorine atom can also be used as an example of the organic group of R⁵, R⁶, or R⁷. Specific examples thereof include the organic groups derived from silicon compounds as shown in paragraphs [0059] to [0065] of JP 2012-53253 A.

### (How to synthesize thermally crosslinkable polysiloxane (Sx))

The thermally crosslinkable polysiloxane in the present invention may be produced by hydrolytic condensation of any of the hydrolyzable monomers (Sm) below.

### (Hydrolyzable monomer (Sm))

The above hydrolyzable monomer (Sm) has one, two, or three chlorine, bromine, iodine, acetoxy, methoxy, ethoxy, propoxy, or butoxy groups, etc. attached, as hydrolyzable groups, onto the silicon indicated by (Si) in the above substructure.

The hydrolyzable monomer (Sm) is a raw material for synthesis of the thermally crosslinkable polysiloxane (Sx) in the present invention. Specific examples thereof include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, isobutyltrimethoxysilane, isobutyltriethoxysilane, isobutyltripropoxysilane, isobutyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, allyltrimethoxysilane, allyltriethoxysilane, allyltripropoxysilane, allyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, cyclopropylmethyltrimethoxysilane, cyclopropylmethyltriethoxysilane, cyclopropylmethyltripropoxysilane, cyclopropylmethyltriisopropoxysilane, cyclobutylmethyltrimethoxysilane, cyclobutylmethyltriethoxysilane, cyclobutylmethyltripropoxysilane, cyclobutylmethyltriisopropoxysilane, cyclopentylmethyltrimethoxysilane, cyclopentylmethyltriethoxysilane, cyclopentylmethyltripropoxysilane, cyclopentylmethyltriisopropoxysilane, cyclohexylmethyltrimethoxysilane, cyclohexylmethyltriethoxysilane, cyclohexylmethyltripropoxysilane, cyclohexylmethyltriisopropoxysilane, phenyltrimethoxysilane, phenyltriethoxysilane, phenyltripropoxysilane, phenyltriisopropoxysilane, benzyltrimethoxysilane, benzyltriethoxysilane, benzyltripropoxysilane, benzyltriisopropoxysilane, methylbenzyltrimethoxysilane, methylbenzyltriethoxysilane, methylbenzyltripropoxysilane, methylbenzyltriisopropoxysilane, ethylbenzyltrimethoxysilane, ethylbenzyltriethoxysilane, ethylbenzyltripropoxysilane, ethylbenzyltriisopropoxysilane, propylbenzyltrimethoxysilane, propylbenzyltriethoxysilane, propylbenzyltripropoxysilane, propylbenzyltriisopropoxysilane, isopropylbenzyltrimethoxysilane, isopropylbenzyltriethoxysilane, isopropylbenzyltripropoxysilane, isopropylbenzyltriisopropoxysilane, fluorobenzyltrimethoxysilane, fluorobenzyltriethoxysilane, fluorobenzyltripropoxysilane, fluorobenzyltriisopropoxysilane, chlorobenzyltrimethoxysilane, chlorobenzyltriethoxysilane, chlorobenzyltripropoxysilane, chlorobenzyltriisopropoxysilane,
bromobenzyltrimethoxysilane, bromobenzyltriethoxysilane, bromobenzyltripropoxysilane, bromobenzyltriisopropoxysilane, iodobenzyltrimethoxysilane, iodobenzyltriethoxysilane, iodobenzyltripropoxysilane, iodobenzyltriisopropoxysilane, methoxybenzyltrimethoxysilane, methoxybenzyltriethoxysilane, methoxybenzyltripropoxysilane, methoxybenzyltriisopropoxysilane, ethoxybenzyltrimethoxysilane, ethoxybenzyltriethoxysilane, ethoxybenzyltripropoxysilane, ethoxybenzyltriisopropoxysilane, propoxybenzyltrimethoxysilane, propoxybenzyltriethoxysilane, propoxybenzyltripropoxysilane, propoxybenzyltriisopropoxysilane, isopropoxybenzyltrimethoxysilane, isopropoxybenzyltriethoxysilane, isopropoxybenzyltripropoxysilane, isopropoxybenzyltriisopropoxysilane, butoxybenzyltrimethoxysilane, butoxybenzyltriethoxysilane, butoxybenzyltripropoxysilane, butoxybenzyltriisopropoxysilane, isobutoxybenzyltrimethoxysilane, isobutoxybenzyltriethoxysilane, isobutoxybenzyltripropoxysilane, isobutoxybenzyltriisopropoxysilane, *sec-*butoxybenzyltrimethoxysilane, *sec-*butoxybenzyltriethoxysilane, *sec-*butoxybenzyltripropoxysilane, *sec-*butoxybenzyltriisopropoxysilane, t-butoxybenzyltrimethoxysilane, t-butoxybenzyltriethoxysilane, t-butoxybenzyltripropoxysilane, t-butoxybenzyltriisopropoxysilane, acetylbenzyltrimethoxysilane, acetylbenzyltriethoxysilane, acetylbenzyltripropoxysilane, acetylbenzyltriisopropoxysilane, hydroxybenzyltrimethoxysilane, hydroxybenzyltriethoxysilane, hydroxybenzyltripropoxysilane, hydroxybenzyltriisopropoxysilane, sulfobenzyltrimethoxysilane, sulfobenzyltriethoxysilane, sulfobenzyltripropoxysilane, sulfobenzyltriisopropoxysilane, nitrobenzyltrimethoxysilane, nitrobenzyltriethoxysilane, nitrobenzyltripropoxysilane, nitrobenzyltriisopropoxysilane, anisyltrimethoxysilane, anisyltriethoxysilane, anisyltripropoxysilane, anisyltriisopropoxysilane, tolyltrimethoxysilane, tolyltriethoxysilane, tolyltripropoxysilane, tolyltriisopropoxysilane, phenethyltrimethoxysilane, phenethyltriethoxysilane, phenethyltripropoxysilane, phenethyltriisopropoxysilane, naphthyltrimethoxysilane, naphthyltriethoxysilane, naphthyltripropoxysilane, naphthyltriisopropoxysilane, naphthylmethyltrimethoxysilane, naphthylmethyltriethoxysilane, naphthylmethyltripropoxysilane, naphthylmethyltriisopropoxysilane, methylnaphthylmethyltrimethoxysilane, methylnaphthylmethyltriethoxysilane, methylnaphthylmethyltripropoxysilane, methylnaphthylmethyltriisopropoxysilane, ethylnaphthylmethyltrimethoxysilane, ethylnaphthylmethyltriethoxysilane, ethylnaphthylmethyltripropoxysilane, ethylnaphthylmethyltriisopropoxysilane, propylnaphthylmethyltrimethoxysilane, propylnaphthylmethyltriethoxysilane, propylnaphthylmethyltripropoxysilane, propylnaphthylmethyltriisopropoxysilane, isopropylnaphthylmethyltrimethoxysilane, isopropylnaphthylmethyltriethoxysilane, isopropylnaphthylmethyltripropoxysilane, isopropylnaphthylmethyltriisopropoxysilane, fluoronaphthylmethyltrimethoxysilane, fluoronaphthylmethyltriethoxysilane, fluoronaphthylmethyltripropoxysilane, fluoronaphthylmethyltriisopropoxysilane, chloronaphthylmethyltrimethoxysilane, chloronaphthylmethyltriethoxysilane, chloronaphthylmethyltripropoxysilane, chloronaphthylmethyltriisopropoxysilane, bromonaphthylmethyltrimethoxysilane,
bromonaphthylmethyltriethoxysilane, bromonaphthylmethyltripropoxysilane, bromonaphthylmethyltriisopropoxysilane, iodonaphthylmethyltrimethoxysilane, iodonaphthylmethyltriethoxysilane, iodonaphthylmethyltripropoxysilane, iodonaphthylmethyltriisopropoxysilane, methoxynaphthylmethyltrimethoxysilane, methoxynaphthylmethyltriethoxysilane, methoxynaphthylmethyltripropoxysilane, methoxynaphthylmethyltriisopropoxysilane, ethoxynaphthylmethyltrimethoxysilane, ethoxynaphthylmethyltriethoxysilane, ethoxynaphthylmethyltripropoxysilane, ethoxynaphthylmethyltriisopropoxysilane, propoxynaphthylmethyltrimethoxysilane, propoxynaphthylmethyltriethoxysilane, propoxynaphthylmethyltripropoxysilane, propoxynaphthylmethyltriisopropoxysilane, isopropoxynaphthylmethyltrimethoxysilane, isopropoxynaphthylmethyltriethoxysilane, isopropoxynaphthylmethyltripropoxysilane, isopropoxynaphthylmethyltriisopropoxysilane, butoxynaphthylmethyltrimethoxysilane, butoxynaphthylmethyltriethoxysilane, butoxynaphthylmethyltripropoxysilane, butoxynaphthylmethyltriisopropoxysilane, isobutoxynaphthylmethyltrimethoxysilane, isobutoxynaphthylmethyltriethoxysilane, isobutoxynaphthylmethyltripropoxysilane, isobutoxynaphthylmethyltriisopropoxysilane, *sec-*butoxynaphthylmethyltrimethoxysilane, *sec-*butoxynaphthylmethyltriethoxysilane, *sec-*butoxynaphthylmethyltripropoxysilane, *sec-*butoxynaphthylmethyltriisopropoxysilane, t-butoxynaphthylmethyltrimethoxysilane, t-butoxynaphthylmethyltriethoxysilane, t-butoxynaphthylmethyltripropoxysilane, t-butoxynaphthylmethyltriisopropoxysilane, acetylnaphthylmethyltrimethoxysilane, acetylnaphthylmethyltriethoxysilane, acetylnaphthylmethyltripropoxysilane, acetylnaphthylmethyltriisopropoxysilane, hydroxynaphthylmethyltrimethoxysilane, hydroxynaphthylmethyltriethoxysilane, hydroxynaphthylmethyltripropoxysilane, hydroxynaphthylmethyltriisopropoxysilane, sulfonaphthylmethyltrimethoxysilane, sulfonaphthylmethyltriethoxysilane, sulfonaphthylmethyltripropoxysilane, sulfonaphthylmethyltriisopropoxysilane, nitronaphthylmethyltrimethoxysilane, nitronaphthylmethyltriethoxysilane, nitronaphthylmethyltripropoxysilane, nitronaphthylmethyltriisopropoxysilane, methoxymethyltrimethoxysilane, methoxymethyltriethoxysilane, methoxymethyltripropoxysilane, methoxymethyltriisopropoxysilane, ethoxymethyltrimethoxysilane, ethoxymethyltriethoxysilane, ethoxymethyltripropoxysilane, ethoxymethyltriisopropoxysilane, propoxymethyltrimethoxysilane, propoxymethyltriethoxysilane, propoxymethyltripropoxysilane, propoxymethyltriisopropoxysilane, isopropoxymethyltrimethoxysilane, isopropoxymethyltriethoxysilane, isopropoxymethyltripropoxysilane, isopropoxymethyltriisopropoxysilane, butoxymethyltrimethoxysilane, butoxymethyltriethoxysilane, butoxymethyltripropoxysilane, butoxymethyltriisopropoxysilane, isobutoxymethyltrimethoxysilane, isobutoxymethyltriethoxysilane, isobutoxymethyltripropoxysilane, isobutoxymethyltriisopropoxysilane, *sec-*butoxymethyltrimethoxysilane, *sec-*butoxymethyltriethoxysilane, *sec-*butoxymethyltripropoxysilane, *sec-*butoxymethyltriisopropoxysilane, t-butoxymethyltrimethoxysilane, t-butoxymethyltriethoxysilane, t-butoxymethyltripropoxysilane, t-butoxymethyltriisopropoxysilane, pentoxymethyltrimethoxysilane, pentoxymethyltriethoxysilane, pentoxymethyltripropoxysilane, pentoxymethyltriisopropoxysilane, isopentoxymethyltrimethoxysilane,
isopentoxymethyltriethoxysilane, isopentoxymethyltripropoxysilane, isopentoxymethyltriisopropoxysilane, *sec-*pentoxymethyltrimethoxysilane, *sec-*pentoxymethyltriethoxysilane, *sec-*pentoxymethyltripropoxysilane, *sec-*pentoxymethyltriisopropoxysilane, 3-pentoxymethyltrimethoxysilane, 3-pentoxymethyltriethoxysilane, 3-pentoxymethyltripropoxysilane, 3-pentoxymethyltriisopropoxysilane, t-pentoxymethyltrimethoxysilane, t-pentoxymethyltriethoxysilane, t-pentoxymethyltripropoxysilane, t-pentoxymethyltriisopropoxysilane, neopentoxymethyltrimethoxysilane, neopentoxymethyltriethoxysilane, neopentoxymethyltripropoxysilane, neopentoxymethyltriisopropoxysilane, fluoromethyltrimethoxysilane, fluoromethyltriethoxysilane, fluoromethyltripropoxysilane, fluoromethyltriisopropoxysilane, chloromethyltrimethoxysilane, chloromethyltriethoxysilane, chloromethyltripropoxysilane, chloromethyltriisopropoxysilane, bromomethyltrimethoxysilane, bromomethyltriethoxysilane, bromomethyltripropoxysilane, bromomethyltriisopropoxysilane, iodomethyltrimethoxysilane, iodomethyltriethoxysilane, iodomethyltripropoxysilane, iodomethyltriisopropoxysilane, hydroxymethyltrimethoxysilane, hydroxymethyltriethoxysilane, hydroxymethyltripropoxysilane, hydroxymethyltriisopropoxysilane, sulfomethyltrimethoxysilane, sulfohydroxymethyltriethoxysilane, sulfomethyltripropoxysilane, sulfomethyltriisopropoxysilane, nitromethyltrimethoxysilane, nitromethyltriethoxysilane, nitromethyltripropoxysilane, nitromethyltriisopropoxysilane, carboxymethyltrimethoxysilane, carboxymethyltriethoxysilane, carboxymethyltripropoxysilane, carboxymethyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl)dimethoxysilane, bis(bicycloheptyl)diethoxysilane, bis(bicycloheptyl)dipropoxysilane, bis(bicycloheptyl)diisopropoxysilane, diadamantyldimethoxysilane, diadamantyldiethoxysilane, diadamantyldipropoxysilane, diadamantyldiisopropoxysilane, diphenyldimethoxysilane, diphenyldiethoxysilane, methylphenyldimethoxysilane, methylphenyldiethoxysilane, diphenyldipropoxysilane, diphenyldiisopropoxysilane, trimethylmethoxysilane, trimethylethoxysilane, dimethylethylmethoxysilane, dimethylethylethoxysilane, dimethylphenylmethoxysilane, dimethylphenylethoxysilane, dimethylnaphthylmethylmethoxysilane, dimethylnaphthylmethylethoxysilane, dimethylphenethylmethoxysilane, and dimethylphenethylethoxysilane.

Preferred examples of the above compounds include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, phenethyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, methylphenyldimethoxysilane, methylphenyldiethoxysilane, trimethylmethoxysilane, dimethylethylmethoxysilane, dimethylphenylmethoxysilane, dimethylbenzylmethoxysilane, and dimethylphenethylmethoxysilane.

The synthesis of the thermally crosslinkable polysiloxane (Sx) will be further described in detail. (Synthesis method 1: acid catalyst)

The thermally crosslinkable polysiloxane (Sx) used in the present invention may be produced by hydrolytic condensation of a mixture of one or two or more hydrolyzable monomers (Sm) in the presence of an acid catalyst.

Examples of the acid catalyst used at this time include an organic acid such as formic acid, acetic acid, oxalic acid, maleic acid, methanesulfonic acid, benzenesulfonic acid, toluene sulfonic acid; hydrofluoric acid, hydrochloric acid, hydrobromic acid, sulfuric acid, nitric acid, perchloric acid, and phosphoric acid. The amount of catalyst used per mol of the monomer is preferably 1 × 10⁻⁶ to 10 mol, more preferably 1 × 10⁻⁵ to 5 mol, and still more preferably 1 × 10⁻⁴ to 1 mol.

When the thermally crosslinkable polysiloxane (Sx) is obtained from these monomers by hydrolytic condensation, the amount of water added is preferably from 0.01 to 100 mol, more preferably from 0.05 to 50 mol, and still more preferably from 0.1 to 30 mol per mol of the hydrolyzable substituent attached to the monomer. If the amount is 100 mol or less, the reactor used for the reaction becomes smaller and more economical. If the amount is 0.01 mol or more, the reaction proceeds satisfactorily.

The operation procedure is as follows: the monomer is added to the aqueous catalyst solution to initiate the hydrolytic condensation reaction. At this time, an organic solvent may be added to the aqueous catalyst solution, the monomer may be diluted with the organic solvent in advance, or both may be performed. The reaction temperature is preferably 0 to 100°C and more preferably from 5 to 80°C. In the method, the temperature is preferably maintained at 5 to 80°C during the drop of the monomer, followed by aging at 20 to 80°C.

Preferred examples of the organic solvent that may be added to the aqueous catalyst solution or with which the monomer may be diluted include methanol, ethanol, 1-propanol, 2-propanol, 1-butanol, 2-butanol, 2-methyl-1-propanol, ethylene glycol, propylene glycol, acetone, acetonitrile, tetrahydrofuran, toluene, hexane, ethyl acetate, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, t-butyl propionate, propylene glycol mono-t-butyl ether acetate, γ-butyrolactone, and mixtures thereof.

Among these organic solvents, those which are water-soluble are preferred. Examples thereof include alcohols such as methanol, ethanol, 1-propanol, **2-**propanol; polyhydric alcohols such as ethylene glycol, propylene glycol; derivatives formed by condensation of polyhydric alcohols such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether), acetone, acetonitrile, and tetrahydrofuran. Among these, those with a boiling point 100°C or less are particularly preferred.

Note that the amount of organic solvent used is preferably 0 to 1,000 ml per mol of the monomer, especially preferably 0 to 500 ml. The smaller amount of organic solvent is used, the smaller reactor is needed and more economical.

Then, if necessary, a catalyst neutralization reaction is carried out to obtain an aqueous solution of the reaction mixture. In this case, the amount of alkaline substance that can be used for neutralization is preferably 0.1 to 2 equivalents per acid used in the catalyst. This alkaline substance may be any substance as long as that exhibits alkalinity in water.

Subsequently, byproducts such as alcohols generated in the hydrolytic condensation reaction are preferably removed from the aqueous solution of the reaction mixture by distillation under reduced pressure other removal means. In this case, the temperature at which the aqueous solution of the reaction mixture is heated depends on the type of organic solvent added and the alcohol generated in the reaction, but is preferably 0 to 100°C, more preferably from 10 to 90°C, and still more preferably from 15 to 80°C. In addition, the degree of reduced pressure at this time varies depending on the type of, for instance, organic solvent and alcohol to be removed, the exhaust apparatus, the condensation apparatus, and the heating temperature, but the pressure is preferably the atmospheric pressure or less, more preferably 80 kPa (absolute pressure) or less, and still more preferably 50 kPa (absolute pressure) or less. It is difficult to know the exact amount of alcohol to be removed in this process, but it is desirable to remove about 80 mass% or more of the alcohol and the like generated.

The acid catalyst used for hydrolytic condensation may then be removed from the aqueous solution of the reaction mixture. As a method to remove the acid catalyst, water and thermally crosslinkable polysiloxane solution are mixed, and the thermally crosslinkable polysiloxane is extracted with an organic solvent. It is preferable that the organic solvent used at this time is an organic solvent that can dissolve the thermally crosslinkable polysiloxane and can be separated into two layers when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, and mixtures thereof.

Further, a mixture of water-soluble organic solvents and poorly water-soluble organic solvents may also be used. Preferred examples thereof include a methanol-ethyl acetate mixture, an ethanol-ethyl acetate mixture, a 1-propanol-ethyl acetate mixture, a 2-propanol-ethyl acetate mixture, a butanediol monomethyl ether-ethyl acetate mixture, a propylene glycol monomethyl ether-ethyl acetate mixture, an ethylene glycol monomethyl ether-ethyl acetate mixture, a butanediol monoethyl ether-ethyl acetate mixture, a propylene glycol monoethyl ether-ethyl acetate mixture, an ethylene glycol monoethyl ether-ethyl acetate mixture, a butanediol monopropyl ether-ethyl acetate mixture, a propylene glycol monopropyl ether-ethyl acetate mixture, an ethylene glycol monopropyl ether-ethyl acetate mixture, a methanol-methyl isobutyl ketone mixture, an ethanol-methyl isobutyl ketone mixture, a 1-propanol-methyl isobutyl ketone mixture, a 2-propanol-methyl isobutyl ketone mixture, a propylene glycol monomethyl ether-methyl isobutyl ketone mixture, an ethylene glycol monomethyl ether-methyl isobutyl ketone mixture, a propylene glycol monoethyl ether-methyl isobutyl ketone mixture, an ethylene glycol monoethyl ether-methyl isobutyl ketone mixture, a propylene glycol monopropyl ether-methyl isobutyl ketone mixture, an ethylene glycol monopropyl ether-methyl isobutyl ketone mixture, a methanol-cyclopentyl methyl ether mixture, an ethanol-cyclopentyl methyl ether mixture, a 1-propanol-cyclopentyl methyl ether mixture, a 2-propanol-cyclopentyl methyl ether mixture, a propylene glycol monomethyl ether-cyclopentyl methyl ether mixture, an ethylene glycol monomethyl ether-cyclopentyl methyl ether mixture, a propylene glycol monoethyl ether-cyclopentyl methyl ether mixture, an ethylene glycol monoethyl ether-cyclopentyl methyl ether mixture, a propylene glycol monopropyl ether-cyclopentyl methyl ether mixture, an ethylene glycol monopropyl ether-cyclopentyl methyl ether mixture, a methanol-propylene glycol methyl ether acetate mixture, an ethanol-propylene glycol methyl ether acetate mixture, a 1-propanol-propylene glycol methyl ether acetate mixture, a 2-propanol-propylene glycol methyl ether acetate mixture, a propylene glycol monomethyl ether-propylene glycol methyl ether acetate mixture, an ethylene glycol monomethyl ether-propylene glycol methyl ether acetate mixture, a propylene glycol monoethyl ether-propylene glycol methyl ether acetate mixture, an ethylene glycol monoethyl ether-propylene glycol methyl ether acetate mixture, a propylene glycol monopropyl ether-propylene glycol methyl ether acetate mixture, and an ethylene glycol monopropyl ether-propylene glycol methyl ether acetate mixture. The combination is not limited thereto.

The mixing ratio between the water-soluble organic solvent and the poorly water-soluble organic solvent is selected, if appropriate, but the mixing ratio is preferably 0.1 to 1,000 parts by mass of water-soluble organic solvent per 100 parts by mass of poorly water-soluble organic solvent, more preferably 1 to 500 parts by mass, and still more preferably 2 to 100 parts by mass.

Subsequently, organic solution of thermally crosslinkable polysiloxane may be washed with water may be performed. This water, usually called deionized water or ultrapure water, may be used. The amount of water is preferably 0.01 to 100 L, more preferably 0.05 to 50 L, and still more preferably 0.1 to 5 L per 1 L of the thermally crosslinkable polysiloxane solution. For this washing method, organic solution of thermally crosslinkable polysiloxane and water may be placed in the same container, stirred, and then allowed to stand to separate the aqueous layer. The number of washing may be operated at least once, but preferably 1 to 5 times, since washing 10 times or more does not yield a proportional improvement.

Other methods to remove the acid catalyst include a method using an ion exchange resin and a method of neutralizating with an epoxy compound such as ethylene oxide, propylene oxide and then remove it. These methods can be selected, if appropriate, according to the acid catalyst used in the reaction.

The water washing operation may cause some of the thermally crosslinkable polysiloxane to escape into the aqueous layer, resulting in an effect that is practically equivalent to the fractionation operation. Therefore, the number of water washing times and the amount of washing water may be selected, if appropriate, in consideration of the catalyst removal effect and the fractionation effect.

In both the thermally crosslinkable polysiloxane solution with a residual acid catalyst and the thermally crosslinkable polysiloxane solution from which the acid catalyst has been removed, the desired thermally crosslinkable polysiloxane solution is obtained by adding a final solvent and exchanging the solvent at reduced pressure. The temperature of the solvent exchange at this time depends on the type of reaction solvent or extraction solvent to be removed, but is preferably from 0 to 100°C, more preferably from 10 to 90°C, and still more preferably from 15 to 80°C. In addition, the degree of reduced pressure at this time varies depending on the type of extraction solvent to be removed, the exhaust apparatus, the condensation apparatus, and the heating temperature, but the pressure is preferably the atmospheric pressure or less, more preferably 80 kPa (absolute pressure) or less, and still more preferably 50 kPa (absolute pressure) or less.

In this case, the thermally crosslinkable polysiloxane may become unstable due to the change of solvent. This is caused by the compatibility of the final solvent with the thermally crosslinkable polysiloxane. However, to prevent this, it is possible to add, as a stabilizer, a monovalent or multivalent or higher alcohol having, as a substituent, the cyclic ether described in paragraphs [0181] to [0182] of JP 2009-126940 A. The amount to be added is preferably 0 to 25 parts by mass, more preferably 0 to 15 parts by mass, and still more preferably 0 to 5 parts by mass per 100 parts by mass of the thermally crosslinkable polysiloxane in the solution before the solvent exchange. In the case of addition, however, 0.5 parts by mass or more is preferred. If necessary, a solvent exchange operation may be performed by adding a monovalent or multivalent or higher alcohol having a cyclic ether as a substituent to the solution before the solvent exchange.

The thermally crosslinkable polysiloxane is preferably kept in solution at an appropriate concentration. At this time, a concentration of 0.1 to 20 mass% is preferred. At such a concentration, the condensation reaction does not proceed further. Thus, the state does not change to a state in which the thermally crosslinkable polysiloxane cannot be redissolved into the organic solvent. It is also economical and desirable because the amount of solvent is reduced.

The preferred final solvent to be added to the thermally crosslinkable polysiloxane solution is an alcohol-based solvent. The particularly preferred final solvent is a monoalkyl ether derivative such as ethylene glycol, diethylene glycol, triethylene glycol, propylene glycol, dipropylene glycol, or butanediol. Specifically the preferred final solvent is butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol or the like.

If these solvents are the main component, a non-alcohol-based solvent may be added as an auxiliary solvent. Examples of the auxiliary solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, and cyclopentyl methyl ether.

As another reaction operation using an acid catalyst, water or a hydrous organic solvent is added to the monomer or an organic solution of the monomer to initiate the hydrolysis reaction. In this case, the catalyst may be added to the monomer or an organic solution of the monomer, or to water or a hydrous organic solvent in advance. The reaction temperature is preferably 0 to 100°C and more preferably from 10 to 80°C. The preferred method includes heating the mixture to 10 to 50°C during dropping the water and then raising the temperature to 20 to 80°C for aging.

In the case of using an organic solvent, water-soluble an organic solvent is preferred. Examples thereof include methanol, ethanol, 1-propanol, **2-**propanol, 1-butanol, 2-butanol, 2-methyl-1-propanol, acetone, tetrahydrofuran, acetonitrile; polyhydric alcohol condensation product derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate and propylene glycol monopropyl ether acetate, and mixtures thereof.

The amount of organic solvent used is preferably 0 to 1,000 ml per mol of the monomer, and especially preferably 0 to 500 ml. The smaller amount of organic solvent is used, the smaller reactor is needed and more economical. The resulting reaction mixture aqueous solution may be post-processed in the same manner as described above to produce a thermally crosslinkable polysiloxane.

### (Synthesis method 2: alkali catalyst)

In addition, the thermally crosslinkable polysiloxane (Sx) may be produced by hydrolytic condensation of a mixture of one or two or more hydrolyzable monomers (Sm) in the presence of an alkali catalyst. Examples of the alkali catalyst used at this time include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethylmonoethanolamine, monomethyldiethanolamine, triethanolamine, diazabicyclooctane, diazabicyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, and calcium hydroxide. The amount of catalyst used per mol of the monomer is preferably 1 × 10⁻⁶ mol to 10 mol, more preferably 1 × 10⁻⁵ mol to 5 mol, and still more preferably 1 × 10⁻⁴ mol to 1 mol.

When a thermally crosslinkable polysiloxane is obtained from the monomer(s) by hydrolytic condensation, the amount of water added is preferably from 0.1 to 50 mol per mol of the hydrolyzable substituent attached to the monomer. If the amount is 50 mol or less, the reactor used for the reaction becomes smaller and more economical. If the amount is 0.1 mol or more, the reaction proceeds satisfactorily.

The operation procedure is as follows: the monomer is added to the aqueous catalyst solution to initiate the hydrolytic condensation reaction. At this time, an organic solvent may be added to the aqueous catalyst solution, the monomer may be diluted with the organic solvent in advance, or both may be performed. The reaction temperature is preferably 0 to 100°C and more preferably from 5 to 80°C. In the method, the temperature is preferably maintained at 5 to 80°C during dropping the monomer, followed by aging at 20 to 80°C.

As the organic solvent that can be added to the alkali catalyst aqueous solution or that can dilute the monomer(s), the same organic solvents exemplified as the organic solvent that can be added to the acid catalyst aqueous solution are preferably used. Note that the amount of organic solvent used is preferably 0 to 1,000 ml per mol of the monomer since the reaction can be carried out economically.

Then, if necessary, neutralization reaction of a catalyst is carried out to obtain an aqueous solution of the reaction mixture. In this case, the amount of acid substance that can be used for neutralization is preferably 0.1 to 2 equivalents per alkaline substance used in the catalyst. This acid substance may be any substance as long as that exhibits acidity in water.

Subsequently, byproducts such as alcohols generated in the hydrolytic condensation reaction are preferably removed from the aqueous solution of the reaction mixture by distillation under reduced pressure or other removal means. In this case, the temperature at which the aqueous solution of the reaction mixture is heated depends on the type of organic solvent added and the alcohol generated in the reaction, but is preferably 0 to 100°C, more preferably 10 to 90°C, and still more preferably from 15 to 80°C. In addition, the degree of reduced pressure at this time varies depending on the type of organic solvent and alcohol to be removed, the exhaust apparatus, the condensation apparatus, and the heating temperature, but the pressure is preferably the atmospheric pressure or less, more preferably 80 kPa (absolute pressure) or less, and still more preferably 50 kPa (absolute pressure) or less. It is difficult to know the exact amount of alcohol to be removed in this process, but it is desirable to remove about 80 mass% or more of the alcohol generated.

Next, the thermally crosslinkable polysiloxane is extracted with an organic solvent to remove the catalyst used for hydrolytic condensation. It is preferable that the organic solvent used at this time is an organic solvent that can dissolve the thermally crosslinkable polysiloxane and can be separated into two layers when mixed with water. Examples thereof include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, y-butyrolactone, methyl isobutyl ketone, cyclopentyl methyl ether, and mixtures thereof.

Further, a mixture of water-soluble organic solvents and poorly water-soluble organic solvents may also be used.

Specific examples of the organic solvent used to remove the alkali catalyst may be the same as the above-mentioned organic solvents specifically exemplified which is used to remove the acid catalyst or as mixtures of water-soluble and poorly water-soluble organic solvents.

Note that the mixing ratio between the water-soluble organic solvent and the poorly water-soluble organic solvent is selected, if appropriate, but is preferably 0.1 to 1,000 parts by mass of water-soluble organic solvent per 100 parts by mass of poorly water-soluble organic solvent, more preferably 1 to 500 parts by mass, and still more preferably 2 to 100 parts by mass.

Subsequently, organic solution of thermally crosslinkable polysiloxane may be washed with neutral water is performed. This water, usually called deionized water or ultrapure water, may be used. The amount of water is preferably 0.01 to 100 L, more preferably 0.05 to 50 L, and still more preferably 0.1 to 5 L per 1 L of the thermally crosslinkable polysiloxane solution. For this washing method, organic solution of thermally crosslinkable polysiloxane and water may be placed in the same container, stirred, and then allowed to stand to separate the aqueous layer. The number of washing operations may be at least once, but preferably from about 1 to 5 times, since washing 10 times or more does not yield a proportional improvement.

The final solvent is added to the washed thermally crosslinkable polysiloxane solution and the solvent is exchanged under reduced pressure. This can produce a desired thermally crosslinkable polysiloxane solution. In this case, the temperature of the solvent exchange depends on the type of extraction solvent to be removed, but is preferably 0 to 100°C, more preferably from 10 to 90°C, and still more preferably from 15 to 80°C. In addition, the degree of reduced pressure reduction at this time varies depending on the type of extraction solvent to be removed, the exhaust apparatus, the condensation apparatus, and the heating temperature, but the pressure is preferably the atmospheric pressure or less, more preferably 80 kPa (absolute pressure) or less, and still more preferably 50 kPa (absolute pressure) or less.

The preferred final solvent to be added to the thermally crosslinkable polysiloxane solution is an alcohol-based solvent. Particularly the preferred final solvent is a monoalkyl ether derivative such as ethylene glycol, diethylene glycol, triethylene glycol, propylene glycol, or dipropylene glycol. Specifically the preferred final solvent is propylene glycol monomethyl ether, ethylene glycol monomethyl ether, propylene glycol monoethyl ether, ethylene glycol monoethyl ether, propylene glycol monopropyl ether, ethylene glycol monopropyl ether, diacetone alcohol or the like.

As another reaction operation using an alkali catalyst, water or a hydrous organic solvent is added to the monomer or organic solution of the monomer to initiate the hydrolysis reaction. In this case, the catalyst may be added to the monomer or an organic solution of the monomer, or to water or a hydrous organic solvent in advance. The reaction temperature is preferably 0 to 100°C and more preferably from 10 to 80°C. The preferred method includes heating the mixture to 10 to 50°C during dropping the water and then raising the temperature to 20 to 80°C for aging.

As the organic solvent that can be used as an organic solution or hydrous organic solvent of the monomer, water-soluble organic solvent are preferred. Examples thereof include methanol, ethanol, 1-propanol, 2-propanol, 1-butanol, 2-butanol, 2-methyl-1-propanol, acetone, tetrahydrofuran, acetonitrile; polyhydric alcohol condensation product derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate and propylene glycol monopropyl ether acetate, and mixtures thereof.

The molecular weight of the thermally crosslinkable polysiloxane obtained by the synthesis method 1 or 2 above can be adjusted by controlling the reaction conditions during polymerization as well as selecting the monomer(s). However, if the weight-average molecular weight is 100,000 or less, no undesired substance is generated and no coating spots occur, so that the molecular weight used is preferably 100,000 or less, more preferably 200 to 50,000, and still more preferably 300 to 30,000. Note that the molecular weight, namely the weight-average molecular weight data above, is expressed in terms of polystyrene by gel permeation chromatography (GPC) using RI as a detector and tetrahydrofuran as an eluent, and polystyrene as a standard.

The physical properties of the thermally crosslinkable polysiloxane used in the present invention vary depending on the type of acid or alkali catalyst used during hydrolytic condensation and the reaction conditions. Therefore, they can be selected, if appropriate, according to the performance of the target resist film.

Further, it is possible to use, as a composition for forming a resist film, a polysiloxane derivative produced under the conditions using the acid or alkali catalyst described above from a mixture of one or two or more hydrolyzable monomers (Sm) and a hydrolyzable metal compound represented by the following formula (Mm):

U(OR⁷)ₘ₇(OR⁸)ₘ₈ (Mm)

wherein R⁷ and R⁸ are each an organic group having 1 to 30 carbon atoms, m7 + m8 are the same number as the valence determined by the type of U, m7 and m8 are integers of 0 or more, and U is an element of Group III, IV, or V of the periodic table excluding carbon and silicon.

The hydrolyzable metal compound represented by the above formula (Mm) used in this case can be exemplified below. When U is boron, examples of the hydrolysable metal compound represented by the formula (Mm) include boron methoxide, boron ethoxide, boron propoxide, boron butoxide, boron amyloxide, boron hexyloxide, boron cyclopentoxide, boron cyclohexyloxide, boron allyloxide, boron phenoxide, boron methoxyethoxide, boric acid, and boron oxide.

When U is aluminum, examples of the hydrolysable metal compound represented by the formula (Mm) include aluminum methoxide, aluminum ethoxide, aluminum propoxide, aluminum butoxide, aluminum amyloxide, aluminum hexyloxide, aluminum cyclopentoxide, aluminum cyclohexyloxide, aluminum allyloxide, aluminum phenoxide, aluminum methoxyethoxide, aluminum ethoxyethoxide, aluminum dipropoxyethylacetoacetate, aluminum dibutoxyethylacetoacetate, aluminum propoxybisethylacetoacetate, aluminum butoxybisethylacetoacetate, aluminum 2,4-pentanedionate, and aluminum 2,2,6,6-tetramethyl-3,5-heptanedionate.

When U is gallium, examples of the hydrolysable metal compound represented by the formula (Mm) include gallium methoxide, gallium ethoxide, gallium propoxide, gallium butoxide, gallium amyloxide, gallium hexyloxide, gallium cyclopentoxide, gallium cyclohexyloxide, gallium allyloxide, gallium phenoxide, gallium methoxyethoxide, gallium ethoxyethoxide, gallium dipropoxyethylacetoacetate, gallium dibutoxyethylacetoacetate, gallium propoxybisethylacetoacetate, gallium butoxybisethylacetoacetate, gallium 2,4-pentanedionate, and gallium 2,2,6,6-tetramethyl-3,5-heptanedionate.

When U is yttrium, examples of the hydrolysable metal compound represented by the formula (Mm) include yttrium methoxide, yttrium ethoxide, yttrium propoxide, yttrium butoxide, yttrium amyloxide, yttrium hexyloxide, yttrium cyclopentoxide, yttrium cyclohexyloxide, yttrium allyloxide, yttrium phenoxide, yttrium methoxyethoxide, yttrium ethoxyethoxide, yttrium dipropoxyethylacetoacetate, yttrium dibutoxyethylacetoacetate, yttrium propoxybisethylacetoacetate, yttrium butoxybisethylacetoacetate, yttrium 2,4-pentanedionate, and yttrium 2,2,6,6-tetramethyl-3,5-heptanedionate.

When U is germanium, examples of the hydrolysable metal compound represented by the formula (Mm) include germanium methoxide, germanium ethoxide, germanium propoxide, germanium butoxide, germanium amyloxide, germanium hexyloxide, germanium cyclopentoxide, germanium cyclohexyloxide, germanium allyloxide, germanium phenoxide, germanium methoxyethoxide, and germanium ethoxyethoxide.

When U is titanium, examples of the hydrolysable metal compound represented by the formula (Mm) include titanium methoxide, titanium ethoxide, titanium propoxide, titanium butoxide, titanium amyloxide, titanium hexyloxide, titanium cyclopentoxide, titanium cyclohexyloxide, titanium allyloxide, titanium phenoxide, titanium methoxyethoxide, titanium ethoxyethoxide, titanium dipropoxybisethylacetoacetate, titanium dibutoxybisethylacetoacetate, titanium dipropoxy-bis-2,4-pentanedionate, and titanium dibutoxy-bis-2,4-pentanedionate.

When U is hafnium, examples of the hydrolysable metal compound represented by the formula (Mm) include hafnium methoxide, hafnium ethoxide, hafnium propoxide, hafnium butoxide, hafnium amyloxide, hafnium hexyloxide, hafnium cyclopentoxide, hafnium cyclohexyloxide, hafnium allyloxide, hafnium phenoxide, hafnium methoxyethoxide, hafnium ethoxyethoxide, hafnium dipropoxybisethylacetoacetate, hafnium dibutoxybisethylacetoacetate, hafnium dipropoxy-bis-2,4-pentanedionate, and hafnium dibutoxy-bis-2,4-pentanedionate.

When U is tin, examples of the hydrolysable metal compound represented by the formula (Mm) include methoxytin, ethoxytin, propoxytin, butoxytin, phenoxytin, methoxyethoxytin, ethoxyethoxytin, tin 2,4-pentanedionate, and tin 2,2,6,6-tetramethyl-3,5-heptanedionate.

When U is arsenic, examples of the hydrolysable metal compound represented by the formula (Mm) include methoxyarsenic, ethoxyarsenic, propoxyarsenic, butoxyarsenic, and phenoxyarsenic.

When U is antimony, examples of the hydrolysable metal compound represented by the formula (Mm) include methoxyanthimony, ethoxyanthimony, propoxyanthimony, butoxyanthimony, phenoxyanthimony, antimony acetate, and antimony propionate.

When U is niobium, examples of the hydrolysable metal compound represented by the formula (Mm) include methoxyniobium, ethoxyniobium, propoxyniobium, butoxyniobium, and phenoxyniobium.

When U is tantalum, examples of the hydrolysable metal compound represented by the formula (Mm) include methoxytantalum, ethoxytantalum, propoxytantalum, butoxytantalum, and phenoxytantalum.

When U is bismuth, examples of the hydrolysable metal compound represented by the formula (Mm) include methoxybismuth, ethoxybismuth, propoxybismuth, butoxybismuth, and phenoxybismuth.

When U is phosphorus, examples of the hydrolysable metal compound represented by the formula (Mm) include trimethyl phosphate, triethyl phosphate, tripropyl phosphate, trimethyl phosphite, triethyl phosphite, tripropyl phosphite, and phosphorus Pentoxide.

When U is vanadium, examples of the hydrolysable metal compound represented by the formula (Mm) include vanadium oxide bis(2,4-pentanedionate), vanadium 2,4-pentanedionate, vanadium tributoxide oxide, and vanadium tripropoxide oxide.

When U is zirconium, examples of the hydrolysable metal compound represented by the formula (Mm) include methoxyzirconium, ethoxyzirconium, propoxyzirconium, butoxyzirconium, phenoxyzirconium, zirconium dibutoxide bis(2,4-pentanedionate), and zirconium dipropoxide bis(2,2,6,6-tetramethyl-3,5-heptanedionate).

In the composition for forming a silicon-containing resist film according to the present invention, the amount of thermally crosslinkable polysiloxane (Sx) is preferably, for example, 0.1 to 10 mass% based on the solvent.

### <Other components>

### [Acid generator]

The composition for forming a silicon-containing resist film according to the present invention preferably further contains an acid generator. The acid generator may be used alone or in combination of two or more. Any substance that acts as an acid precursor such as the acid generator, a thermos-acid generator, a photoacid generator or an acid amplifier, may be used.

In the present invention, the acid generator is preferably a photoacid generator that generates an acid by the action of high-energy rays, and the acid generator is preferably a sulfonium salt. More specifically, examples of the materials include those described in paragraphs[0160] to [0179] of JP 2009-126940 A, but are not limited thereto. The amount of acid generator is preferably 0 to 10 parts by mass and more preferably 0.1 to 5 parts by mass based on 100 parts by mass of thermally crosslinkable polysiloxane (Sx).

By adding an acid generator as necessary, the pattern shape, exposure sensitivity, etc., can be fine-tuned.

### (Crosslinking catalyst)

The composition for forming a silicon-containing resist film according to the present invention may comprise a crosslinking catalyst. With such a composition for forming a silicon-containing resist film, it is possible to moderately adjust the pattern shape, exposure sensitivity, etc., of the resist film while minimizing the degradation of other performances, and in addition, it is effective in decreasing the residue derived from the resist film.

Examples of the crosslinking catalyst (Xc) that can be added include the compound represented by the following formula (Xc0):

LₐH_{b}A (Xc0)

wherein, L is lithium, sodium, potassium, rubidium, cesium, sulfonium, iodonium, phosphonium, or ammonium; A is a non-nucleophilic counter ion; "a" is an integer of 1 or more; "b" is an integer 0 or 1 or more; and a + b is the valence of the non-nucleophilic counter ion.

Specific examples of the crosslinking catalyst (Xc) used in the present invention as a compound represented by the formula (Xc0) include a sulfonium salt of the following formula (Xc-1), an iodonium salt of (Xc-2), a phosphonium salt of (Xc-3), an ammonium salt of (Xc-4), and an alkali metal salt.

The crosslinking catalyst (Xc) used in the present invention is preferably a sulfonium salt of the following formula (Xc-1) or an ammonium salt of (Xc-4).

The sulfonium salt (Xc-1), iodonium salt (Xc-2), phosphonium salt (Xc-3), and ammonium salt (Xc-4) will be described. 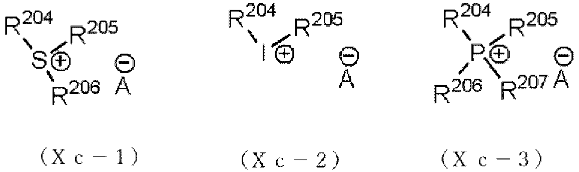 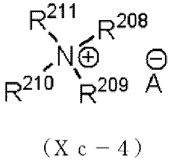 wherein R²⁰⁴, R²⁰⁵, R²⁰⁶, and R²⁰⁷ each represent a linear, branched, or cyclic alkyl, alkenyl, oxoalkyl, or oxoalkenyl group having 1 to 12 carbon atoms, a substituted or unsubstituted aryl group having 6 to 20 carbon atoms, or an aralkyl or aryloxoalkyl group having 7 to 12 carbon atoms where some or all of hydrogen atoms of these groups may be substituted by alkoxy groups or the like; in addition, R²⁰⁵ and R²⁰⁶ may form a ring, and when the ring is formed, R²⁰⁵ and R²⁰⁶ each represent an alkylene group having 1 to 6 carbon atoms; A- represents a non-nucleophilic counter ion; R²⁰⁸, R²⁰⁹, R²¹⁰, and R²¹¹ are the same as R²⁰⁴, R²⁰⁵, R²⁰⁶, and R²⁰⁷, but may be hydrogen atoms; and R²⁰⁸ and R²⁰⁹, or R²⁰⁸, R²⁰⁹ and R²¹⁰ may form a ring, and when the ring is formed, R²⁰¹ and R²⁰⁹, and R²⁰⁸, R²⁰⁹ and R²¹⁰ represent an alkylene group having 3 to 10 carbon atoms.

R²⁰⁴, R²⁰⁵, R²⁰⁶, R²⁰⁷, R²⁰⁸, R²⁰⁹, R²¹⁰, and R²¹¹ above may be identical or different from each other. Specific examples of the alkyl group include methyl, ethyl, propyl, isopropyl, n-butyl, sec-butyl, tert-butyl, pentyl, hexyl, heptyl, octyl, cyclopentyl, cyclohexyl, cycloheptyl, cyclopropylmethyl, 4-methylcyclohexyl, cyclohexylmethyl, norbornyl, and adamantyl. Examples of the alkenyl group include vinyl, allyl, propenyl, butenyl, hexenyl, and cyclohexenyl. Examples of the oxoalkyl group include 2-oxocyclopentyl, 2-oxocyclohexyl, 2-oxopropyl, 2-cyclopentyl-2-oxoethyl, 2-cyclohexyl-2-oxoethyl, and 2-(4-methylcyclohexyl)-2-oxoethyl. Examples of the oxoalkenyl group include 2-oxopropenyl, 2-oxobutenyl, 2-oxohexenyl, 2-oxocyclopentenyl, and 2-oxocyclohexenyl. Examples of the aryl group include: phenyl, naphthyl, etc.; alkoxyphenyl such as p-methoxyphenyl, m-methoxyphenyl, o-methoxyphenyl, ethoxyphenyl, p-tert-butoxyphenyl, m-tert-butoxyphenyl; alkylphenyl such as 2-methylphenyl, 3-methylphenyl, 4-methylphenyl, ethylphenyl, 4-tert-butylphenyl, 4-butylphenyl, dimethylphenyl; alkylnaphthyl such as methylnaphthyl, ethylnaphthyl); alkoxynaphthyl such as methoxynaphthyl, ethoxynaphthyl; dialkylnaphthyl such as dimethylnaphthyl, diethylnaphthyl; and dialkoxynaphthyl such as dimethoxynaphthyl, diethoxynaphthyl. Examples of the aralkyl group include benzyl, 1-phenylethyl, and phenethyl. Examples of the aryloxoalkyl group include such as 2-phenyl-2-oxoethyl, 2-(1-naphthyl)-2-oxoethyl, 2-(2-naphthyl)-2-oxoethyl.

Examples of the non-nucleophilic counter ion of Ain the above (Xc-1) to (Xc-4) include a monovalent ion such as a hydroxide ion, a formate ion, an acetate ion, a propionate ion, a butyrate ion, a pentanoate ion, a hexanoate ion, a heptanoate ion, an octanoate ion, a nonanoate ion, a decanoate ion, an oleate ion, a stearate ion, a linoleate ion, a linolenate ion, a benzoate ion, a phthalate ion, an isophthalate ion, a terephthalate ion, a salicylate ion, a trifluoroacetate ion, a monochloroacetate ion, a dichloroacetate ion, a trichloroacetate ion, a fluoride ion, a chloride ion, a bromide ion, an iodide ion, a nitrate ion, a nitrite ion, a chlorate ion, a bromate ion, a methanesulfonate ion, a p-toluenesulfonate ion, or a monomethyl sulfate ion; a monovalent or divalent ion such as oxalate ion, a malonate ion, a methylmalonate ion, a ethylmalonate ion, a propylmalonate ion, a butylmalonate ion, a dimethylmalonate ion, a diethylmalonate ion, a succinate ion, a methylsuccinate ion, a glutarate ion, an adipate ion, an itaconate ion, a maleate ion, a fumarate ion, a citraconate ion, a citrate ion, a carbonate ion, and a sulfate ion.

Examples of the alkali metal salt include a hydroxide of lithium, sodium, potassium, cesium, magnesium, or calcium; a monovalent salt such as formate, acetate, propionate, butyrate, pentanoate, hexanoate, heptanoate, octanoate, nonanoate, decanoate, oleate, stearate, linoleate, linolenate, benzoate, phthalate, isophthalate, terephthalate, salicylate, trifluoroacetate, monochloroacetate, dichloroacetate, trichloroacetate; a monovalent or divalent ion such as oxalate, malonate, methylmalonate, ethylmalonate, propylmalonate, butylmalonate, dimethylmalonate, diethylmalonate, succinate, methylsuccinate, glutarate, adipate, itaconate, maleate, fumarate, citraconate, citrate, and carbonate.

Specific examples of the sulfonium salt (Xc-1) include triphenylsulfonium formate, triphenylsulfonium acetate, triphenylsulfonium propionate, triphenylsulfonium butyrate, triphenylsulfonium benzoate, triphenylsulfonium phthalate, triphenylsulfonium isophthalate, triphenylsulfonium terephthalate, triphenylsulfonium salicylate, triphenylsulfonium trifluoromethanesulfonate, triphenylsulfonium trifluoroacetate, triphenylsulfonium monochloroacetate, triphenylsulfonium dichloroacetate, triphenylsulfonium trichloroacetate, triphenylsulfonium hydroxide, triphenylsulfonium nitrate, triphenylsulfonium chloride, triphenylsulfonium bromide, triphenylsulfonium oxalate, triphenylsulfonium malonate, triphenylsulfonium methylmalonate, triphenylsulfonium ethylmalonate, triphenylsulfonium propylmalonate, triphenylsulfonium butylmalonate, triphenylsulfonium dimethylmalonate, triphenylsulfonium diethylmalonate, triphenylsulfonium succinate, triphenylsulfonium methylsuccinate, triphenylsulfonium glutarate, triphenylsulfonium adipate, triphenylsulfonium itaconate, triphenylsulfonium maleate, triphenylsulfonium fumarate, triphenylsulfonium citraconate, triphenylsulfonium citrate, triphenylsulfonium carbonate, bis(triphenylsulfonium) oxalate, bis(triphenylsulfonium) maleate, bis(triphenylsulfonium) fumarate, bis(triphenylsulfonium) citraconate, bis(triphenylsulfonium) citrate, and bis(triphenylsulfonium) carbonate.

Specific examples of the iodonium salt (Xc-2) include diphenyliodonium formate, diphenyliodonium acetate, diphenyliodonium propionate, diphenyliodonium butyrate, diphenyliodonium benzoate, diphenyliodonium phthalate, diphenyliodonium isophthalate, diphenyliodonium terephthalate, diphenyliodonium salicylate, diphenyliodonium trifluoromethanesulfonate, diphenyliodonium trifluoroacetate, diphenyliodonium monochloroacetate, diphenyliodonium dichloroacetate, diphenyliodonium trichloroacetate, diphenyliodonium hydroxide, diphenyliodonium nitrate, diphenyliodonium chloride, diphenyliodonium bromide, diphenyliodonium iodide, diphenyliodonium oxalate, diphenyliodonium maleate, diphenyliodonium fumarate, diphenyliodonium citraconate, diphenyliodonium citrate, diphenyliodonium carbonate, bis(diphenyliodonium) oxalate, bis(diphenyliodonium) maleate, bis(diphenyliodonium) fumarate, bis(diphenyliodonium) citraconate, bis(diphenyliodonium) citrate, and bis(diphenyliodonium) carbonate.

In addition, specific examples of the phosphonium salt (Xc-3) include tetraethylphosphonium formate, tetraethylphosphonium acetate, tetraethylphosphonium propionate, tetraethylphosphonium butyrate, tetraethylphosphonium benzoate, tetraethylphosphonium phthalate, tetraethylphosphonium isophthalate, tetraethylphosphonium terephthalate, tetraethylphosphonium salicylate, tetraethylphosphonium trifluoromethanesulfonate, tetraethylphosphonium trifluoroacetate, tetraethylphosphonium monochloroacetate, tetraethylphosphonium dichloroacetate, tetraethylphosphonium trichloroacetate, tetraethylphosphonium hydroxide, tetraethylphosphonium nitrate, tetraethylphosphonium chloride, tetraethylphosphonium bromide, tetraethylphosphonium iodide, tetraethylphosphonium oxalate, tetraethylphosphonium maleate, tetraethylphosphonium fumarate, tetraethylphosphonium citraconate, tetraethylphosphonium citrate, tetraethylphosphonium carbonate, bis(tetraethylphosphonium) oxalate, bis(tetraethylphosphonium) maleate, bis(tetraethylphosphonium) fumarate, bis(tetraethylphosphonium) citraconate, bis(tetraethylphosphonium) citrate, bis(tetraethylphosphonium) carbonate tetraphenylphosphonium formate, tetraphenylphosphonium acetate, tetraphenylphosphonium propionate, tetraphenylphosphonium butyrate, tetraphenylphosphonium benzoate, tetraphenylphosphonium phthalate, tetraphenylphosphonium isophthalate, tetraphenylphosphonium terephthalate, tetraphenylphosphonium salicylate, tetraphenylphosphonium trifluoromethanesulfonate, tetraphenylphosphonium trifluoroacetate, tetraphenylphosphonium monochloroacetate, tetraphenylphosphonium dichloroacetate, tetraphenylphosphonium trichloroacetate, tetraphenylphosphonium hydroxide, tetraphenylphosphonium nitrate, tetraphenylphosphonium chloride, tetraphenylphosphonium bromide, tetraphenylphosphonium iodide, tetraphenylphosphonium oxalate, tetraphenylphosphonium maleate, tetraphenylphosphonium fumarate, tetraphenylphosphonium citraconate, tetraphenylphosphonium citrate, tetraphenylphosphonium carbonate, bis(tetraphenylphosphonium) oxalate, bis(tetraphenylphosphonium) maleate, bis(tetraphenylphosphonium) fumarate, bis(tetraphenylphosphonium) citraconate, bis(tetraphenylphosphonium) citrate, and bis(tetraphenylphosphonium) carbonate.

Meanwhile, specific examples of the ammonium salt (Xc-4) include tetramethylammonium formate, tetramethylammonium acetate, tetramethylammonium propionate, tetramethylammonium butyrate, tetramethylammonium benzoate, tetramethylammonium phthalate, tetramethylammonium isophthalate, tetramethylammonium terephthalate, tetramethylammonium salicylate, tetramethylammonium trifluoromethanesulfonate, tetramethylammonium trifluoroacetate, tetramethylammonium monochloroacetate, tetramethylammonium dichloroacetate, tetramethylammonium trichloroacetate, tetramethylammonium hydroxide, tetramethylammonium nitrate, tetramethylammonium chloride, tetramethylammonium bromide, tetramethylammonium iodide, tetramethylammonium monomethyl sulfate, tetramethylammonium oxalate, tetramethylammonium malonate, tetramethylammonium maleate, tetramethylammonium fumarate, tetramethylammonium citraconate, tetramethylammonium citrate, tetramethylammonium carbonate, bis(tetramethylammonium) oxalate, bis(tetramethylammonium) malonate, bis(tetramethylammonium) maleate, bis(tetramethylammonium) fumarate, bis(tetramethylammonium) citraconate, bis(tetramethylammonium) citrate, bis(tetramethylammonium) carbonate, tetraethylammonium formate, tetraethylammonium acetate, tetraethylammonium propionate, tetraethylammonium butyrate, tetraethylammonium benzoate, tetraethylammonium phthalate, tetraethylammonium isophthalate, tetraethylammonium terephthalate, tetraethylammonium salicylate, tetraethylammonium trifluoromethanesulfonate, tetraethylammonium trifluoroacetate, tetraethylammonium monochloroacetate, tetraethylammonium dichloroacetate, tetraethylammonium trichloroacetate, tetraethylammonium hydroxide, tetraethylammonium nitrate, tetraethylammonium chloride, tetraethylammonium bromide, tetraethylammonium iodide, tetraethylammonium monomethyl sulfate, tetraethylammonium oxalate, tetraethylammonium malonate, tetraethylammonium maleate, tetraethylammonium fumarate, tetraethylammonium citraconate, tetraethylammonium citrate, tetraethylammonium carbonate, bis(tetraethylammonium) oxalate, bis(tetraethylammonium) malonate, bis(tetraethylammonium) maleate, bis(tetraethylammonium) fumarate, bis(tetraethylammonium) citraconate, bis(tetraethylammonium) citrate, bis(tetraethylammonium) carbonate, tetrapropylammonium formate, tetrapropylammonium acetate, tetrapropylammonium propionate, tetrapropylammonium butyrate, tetrapropylammonium benzoate, tetrapropylammonium phthalate, tetrapropylammonium isophthalate, tetrapropylammonium terephthalate, tetrapropylammonium salicylate, tetrapropylammonium trifluoromethanesulfonate, tetrapropylammonium trifluoroacetate, tetrapropylammonium monochloroacetate, tetrapropylammonium dichloroacetate, tetrapropylammonium trichloroacetate, tetrapropylammonium hydroxide, tetrapropylammonium nitrate, tetrapropylammonium chloride, tetrapropylammonium bromide, tetrapropylammonium iodide, tetrapropylammonium monomethyl sulfate, tetrapropylammonium oxalate, tetrapropylammonium malonate, tetrapropylammonium maleate, tetrapropylammonium fumarate, tetrapropylammonium citraconate, tetrapropylammonium citrate, tetrapropylammonium carbonate, bis(tetrapropylammonium) oxalate, bis(tetrapropylammonium) malonate, bis(tetrapropylammonium) maleate, bis(tetrapropylammonium) fumarate, bis(tetrapropylammonium) citraconate, bis(tetrapropylammonium) citrate, bis(tetrapropylammonium) carbonate, tetrabutylammonium formate, tetrabutylammonium acetate, tetrabutylammonium propionate, tetrabutylammonium butyrate, tetrabutylammonium benzoate, tetrabutylammonium phthalate, tetrabutylammonium isophthalate, tetrabutylammonium terephthalate, tetrabutylammonium salicylate, tetrabutylammonium trifluoromethanesulfonate, tetrabutylammonium trifluoroacetate, tetrabutylammonium monochloroacetate, tetrabutylammonium dichloroacetate, tetrabutylammonium trichloroacetate, tetrabutylammonium hydroxide, tetrabutylammonium nitrate, tetrabutylammonium chloride, tetrabutylammonium bromide, tetrabutylammonium iodide, tetrabutylammonium methanesulfonate, tetrabutylammonium monomethyl sulfate, tetrabutylammonium oxalate, tetrabutylammonium malonate, tetrabutylammonium maleate, tetrabutylammonium fumarate, tetrabutylammonium citraconate, tetrabutylammonium citrate, tetrabutylammonium carbonate, bis(tetrabutylammonium) oxalate, bis(tetrabutylammonium) malonate, bis(tetrabutylammonium) maleate, bis(tetrabutylammonium) fumarate, bis(tetrabutylammonium) citraconate, bis(tetrabutylammonium) citrate, and bis(tetrabutylammonium) carbonate.

Examples of the alkali metal salt include lithium formate, lithium acetate, lithium propionate, lithium butyrate, lithium benzoate, lithium phthalate, lithium isophthalate, lithium terephthalate, lithium salicylate, lithium trifluoromethanesulfonate, lithium trifluoroacetate, lithium monochloroacetate, lithium dichloroacetate, lithium trichloroacetate, lithium hydroxide, lithium nitrate, lithium chloride, lithium bromide, lithium iodide, lithium methanesulfonate, lithium hydrogen oxalate, lithium hydrogen malonate, lithium hydrogen maleate, lithium hydrogen fumarate, lithium hydrogen citraconate, lithium hydrogen citrate, lithium hydrogen carbonate, lithium oxalate, lithium malonate, lithium maleate, lithium fumarate, lithium citraconate, lithium citrate, lithium carbonate, sodium formate, sodium acetate, sodium propionate, sodium butyrate, sodium benzoate, sodium phthalate, sodium isophthalate, sodium terephthalate, sodium salicylate, sodium trifluoromethanesulfonate, sodium trifluoroacetate, sodium monochloroacetate, sodium dichloroacetate, sodium trichloroacetate, sodium hydroxide, sodium nitrate, sodium chloride, sodium bromide, sodium iodide, sodium methanesulfonate, sodium hydrogen oxalate, sodium hydrogen malonate, sodium hydrogen maleate, sodium hydrogen fumarate, sodium hydrogen citraconate, sodium hydrogen citrate, sodium hydrogen carbonate, sodium oxalate, sodium malonate, sodium maleate, sodium fumarate, sodium citraconate, sodium citrate, sodium carbonate, potassium formate, potassium acetate, potassium propionate, potassium butyrate, potassium benzoate, potassium phthalate, potassium isophthalate, potassium terephthalate, potassium salicylate, potassium trifluoromethanesulfonate, potassium trifluoroacetate, potassium monochloroacetate, potassium dichloroacetate, potassium trichloroacetate, potassium hydroxide, potassium nitrate, potassium chloride, potassium bromide, potassium iodide, potassium methanesulfonate, potassium hydrogen oxalate, potassium hydrogen malonate, potassium hydrogen maleate, potassium hydrogen fumarate, potassium hydrogen citraconate, potassium hydrogen citrate, potassium hydrogen carbonate, potassium oxalate, potassium malonate, potassium maleate, potassium fumarate, potassium citraconate, potassium citrate, and potassium carbonate.

### (Polysiloxane (Xc-10) with crosslinking catalyst as part of structure in molecule)

In the present invention, a polysiloxane (Xc-10) having an ammonium salt, a sulfonium salt, a phosphonium salt, or an iodonium salt as a crosslinking catalyst (Xc) as part of its structure may be added into the composition for forming a resist film.

As a raw material used to produce (Xc-10) used here, it is possible to use the compound represented by the following formula (Xm):

R^{1A}_{A1}R^{2A}_{A2}R^{3A}_{A3}Si(OR^{0A})_{(4-A1-A2-A3)} (Xm)

wherein, R^{0A} is a hydrocarbon group having 1 to 6 carbon atoms; at least one of R^{1A}, R^{2A}, or R^{3A} is an organic group having an ammonium salt, a sulfonium salt, a phosphonium salt, or an iodonium salt, and the others are a hydrogen atom or a monovalent organic group having 1 to 30 carbon atoms; A1, A2, and A3 are 0 or 1; and 1 ≤ A1 + A2 + A3 ≤3.

Here, examples of R^{0A} include methyl, ethyl, n-propyl, iso-propyl, n-butyl, iso-butyl, sec-butyl, tert-butyl, n-pentyl, cyclopentyl, n-hexyl, cyclohexyl, and phenyl.

Examples of the Xm include a hydrolyzable silicon compound having a sulfonium salt as part of its structure, namely a compound represented by the following formula (Xm-1): 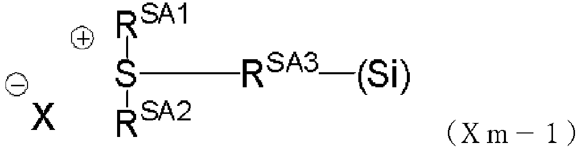 wherein, R^{SA1} and R^{SA2} each represent a linear, branched, or cyclic alkyl, alkenyl, oxoalkyl, or oxoalkenyl group having 1 to 20 carbon atoms, a substituted or unsubstituted aryl group having 6 to 20 carbon atoms, or an aralkyl or aryloxyalkyl group having 7 to 20 carbon atoms where some or all of hydrogen atoms of these groups may be substituted by alkoxy groups, amino groups, alkylamino groups, and/or halogen atoms, etc.; in addition, R^{SA1} and R^{SA2}, together with a sulfur atom to which these are attached, may form a ring, and

when the ring is formed, R^{SA1} and R^{SA2} each represent an alkylene group having 1 to 6 carbon atoms; and R^{SA3} represents a linear, branched, or cyclic alkylene or alkenylene group having 1 to 20 carbon atoms, or a substituted or unsubstituted arylene group having 6 to 20 carbon atoms where some or all of hydrogen atoms of these groups may be substituted by alkoxy groups, amino groups, alkylamino groups, etc.

Note that in the above formula (Xm-1), (Si) is used to indicate the site of bonding to **Si.**

Examples of the **X-** include a hydroxide ion, a fluoride ion, a chloride ion, a bromide ion, an iodide ion, a formate ion, an acetate ion, a propionate ion, a butanoate ion, a pentanoate ion, a hexanoate ion, a heptanoate ion, an octanoate ion, a nonanoate ion, a decanoate ion, an oleate ion, a stearate ion, a linoleate ion, a linolenate ion, a benzoate ion, a **p-**methylbenzoate ion, a p-tert-butylbenzoate ion, a phthalate ion, an isophthalate ion, a terephthalate ion, a salicylate ion, a trifluoroacetate ion, a monochloroacetate ion, a dichloroacetate ion, a trichloroacetate ion, a nitrate ion, a chlorate ion, a perchlorate ion, a bromate ion, an iodate ion, a methanesulfonate ion, a benzenesulfonate ion, a toluenesulfonate ion, a monomethyl sulfate ion, a hydrogen sulfate ion, an oxalate ion, a malonate ion, a methylmalonate ion, a ethylmalonate ion, a propylmalonate ion, a butylmalonate ion, a dimethylmalonate ion, a diethylmalonate ion, a succinate ion, a methylsuccinate ion, a glutarate ion, an adipate ion, an itaconate ion, a maleate ion, a fumarate ion, a citraconate ion, a citrate ion, and a carbonate ion.

As the cationic moiety of the compound represented by the above formula (Xm-1), specifically, the following ions are exemplified.

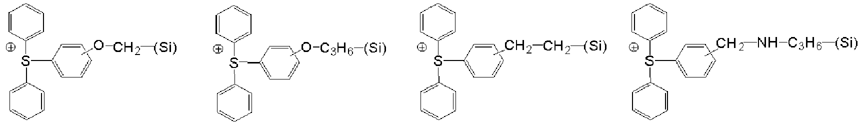

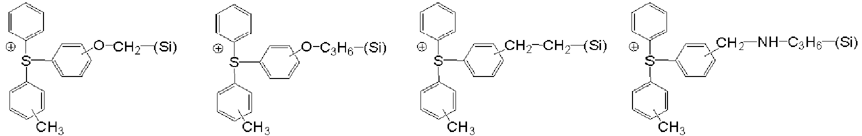

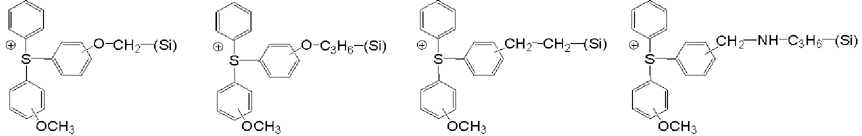

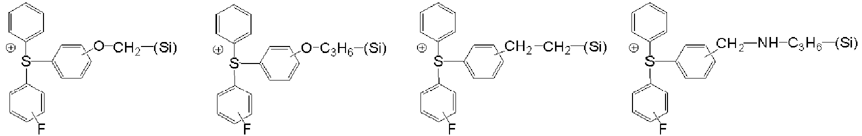

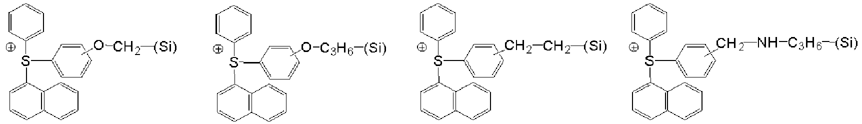

As Xm, for example, a compound represented by the following formula (Xm-2), which is a hydrolyzable silicon compound having an iodonium salt as a part of its structure, can be exemplified: 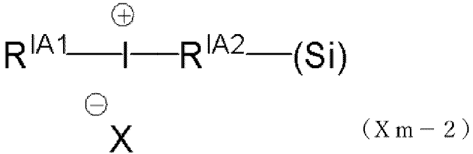 wherein, R^{IA1} represents a linear, branched, or cyclic alkyl, alkenyl, oxoalkyl, or oxoalkenyl group having 1 to 20 carbon atoms, a substituted or unsubstituted aryl group having 6 to 20 carbon atoms, or an aralkyl or aryloxoalkyl group having 7 to 20 carbon atoms where some or all of hydrogen atoms of these groups may be substituted by alkoxy groups, amino groups, alkylamino groups, and/or halogen atoms, etc.; R^{IA2} represents a linear, branched, or cyclic alkylene or alkenylene group having 1 to 20 carbon atoms, or a substituted or unsubstituted arylene group having 6 to 20 carbon atoms where some or all of hydrogen atoms of these groups may be substituted by alkoxy groups, amino groups, alkylamino groups, etc.

Note that in the above formula (Xm-2), (Si) is used to indicate the site of bonding to Si. X- is described as above.

As the cationic moiety of the compound represented by the above formula (Xm-2), specifically, the following ions are exemplified.

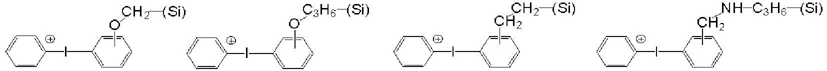

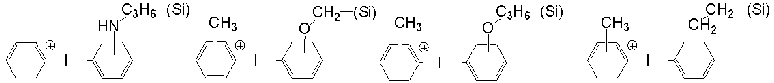

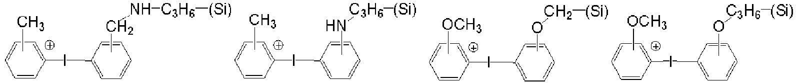

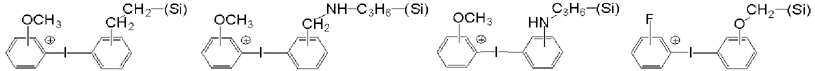

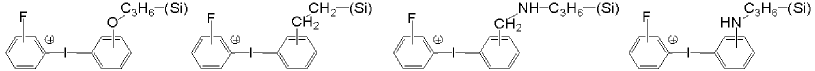

As Xm, for example, a compound represented by the following formula (Xm-3), which is a hydrolyzable silicon compound having a phosphonium salt as a part of its structure, can be exemplified: 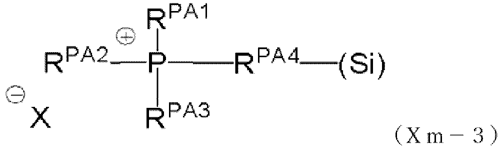 wherein, R^{PA1}, R^{PA2}, and R^{PA3} each represent a linear, branched, or cyclic alkyl, alkenyl, oxoalkyl, or oxoalkenyl group having 1 to 20 carbon atoms, a substituted or unsubstituted aryl group having 6 to 20 carbon atoms, or an aralkyl or aryloxoalkyl group having 7 to 20 carbon atoms where some or all of hydrogen atoms of these groups may be substituted by alkoxy groups, amino groups, alkylamino groups, and/or halogen atoms, etc.; in addition, R^{PA1} and R^{PA2}, together with a phosphorus atom to which these are attached, may form a ring, and when the ring is formed, R^{PA1} and R^{PA2} each represent an alkylene group having 1 to 6 carbon atoms; and R^{PA4} is a linear, branched, or cyclic alkylene or alkenylene group having 1 to 20 carbon atoms, or a substituted or unsubstituted arylene group having 6 to 20 carbon atoms where some or all of hydrogen atoms of these groups may be substituted by alkoxy groups, amino groups, alkylamino groups, etc.

Note that in the above formula (Xm-3), (Si) is used to indicate the site of bonding to Si. X- is described as above.

As the cationic moiety of the compound represented by the above formula (Xm-3), specifically, the following ions are exemplified.

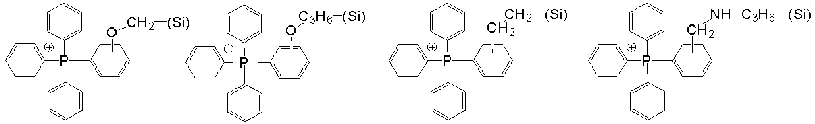

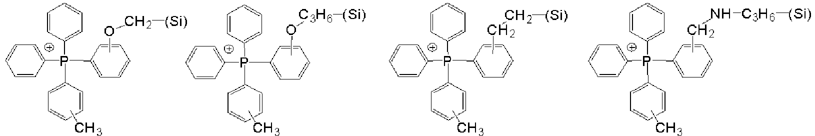

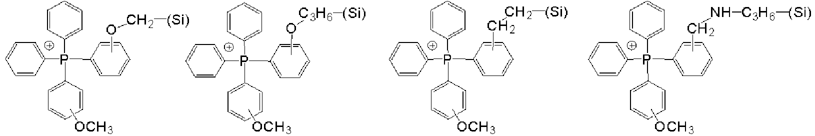

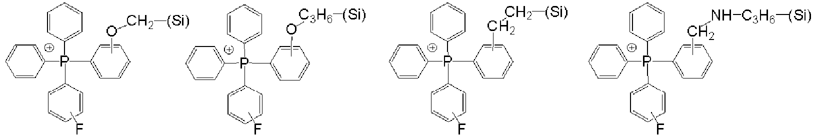

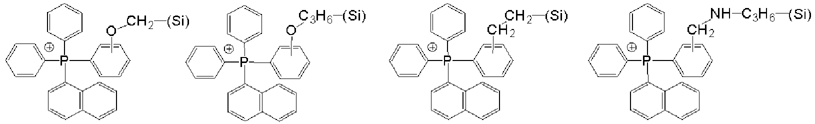

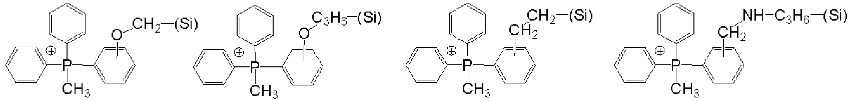

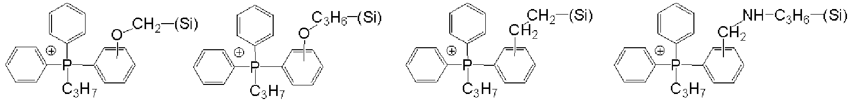

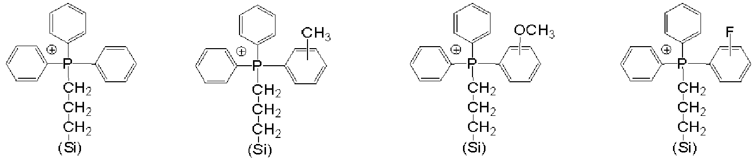

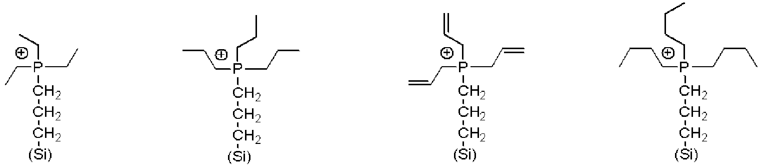

As Xm, for example, a compound represented by the following formula (Xm-4), which is a hydrolyzable silicon compound having an ammonium salt as a part of its structure, can be exemplified: 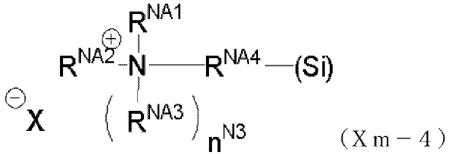 wherein, R^{NA1}, R^{NA2}, and R^{NA3} each represent a hydrogen atom, a linear, branched, or cyclic alkyl, alkenyl, oxoalkyl, or oxoalkenyl group having 1 to 20 carbon atoms, a substituted or unsubstituted aryl group having 6 to 20 carbon atoms, or an aralkyl or aryloxyalkyl group having 7 to 20 carbon atoms where some or all of hydrogen atoms of these groups may be substituted by alkoxy groups, amino groups, alkylamino groups, etc.; in addition, R^{NA1} and R^{NA2}, together with a nitrogen atom to which these are attached, may form a ring, and when the ring is formed, R^{NA1} and R^{NA2} each represent an alkylene group having 1 to 6 carbon atoms, or a nitrogen-containing cyclic heterocycle or heteroaromatic ring; R^{NA4} represents a linear, branched, or cyclic alkylene or alkenylene group having 1 to 20 carbon atoms, or a substituted or unsubstituted arylene group having 6 to 20 carbon atoms where some or all of hydrogen atoms of these groups may be substituted by alkoxy groups, amino groups, alkylamino groups, etc.; and R^{NA1} and R^{NA2} or R^{NA1} and R^{NA4} form a ring structure, when further contain unsaturated nitrogen, nN3 = 0, otherwise nN3 = 1.

Note that in the above formula (Xm-4), (Si) is used to indicate the site of bonding to Si. X- is described as above.

As the cationic moiety of the compound represented by the above formula (Xm-4), specifically, the following ions are exemplified.

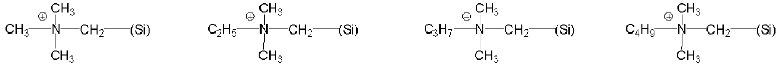

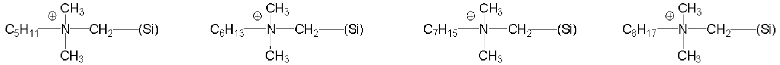

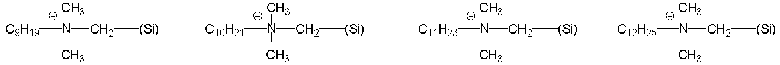

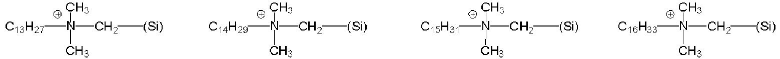

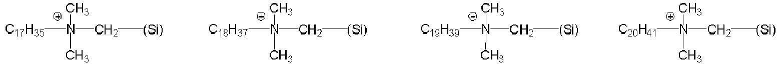

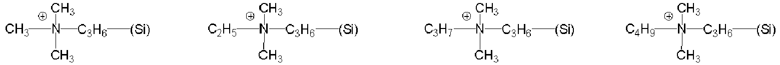

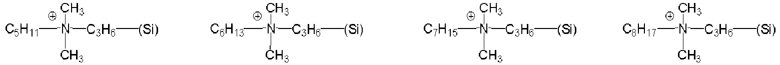

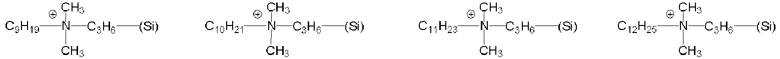

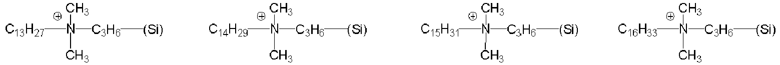

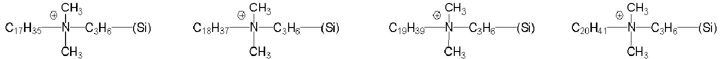

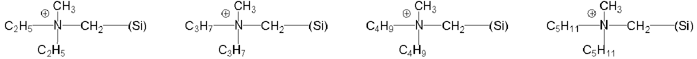

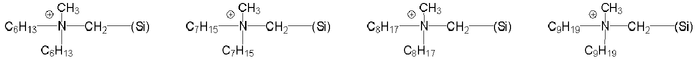

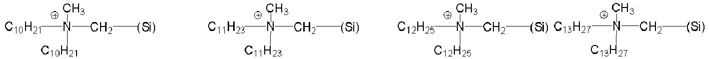

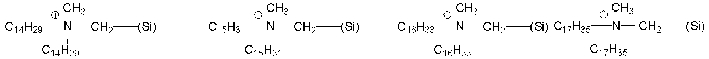

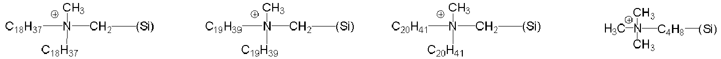

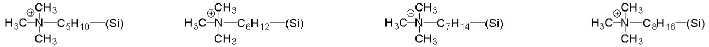

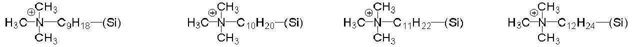

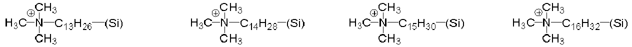

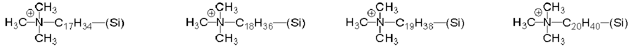

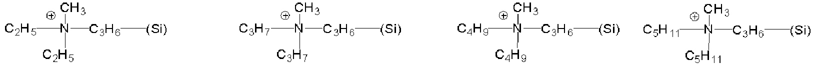

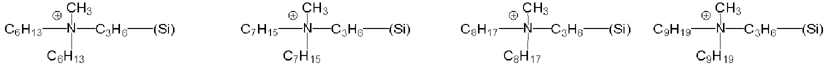

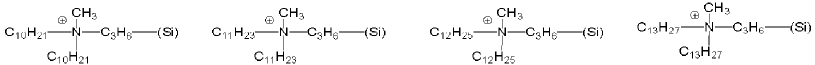

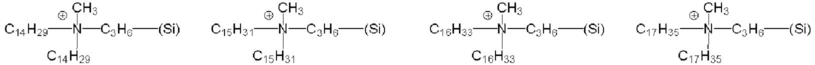

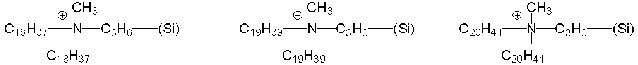

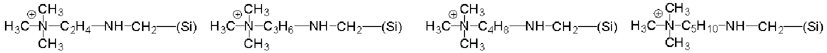

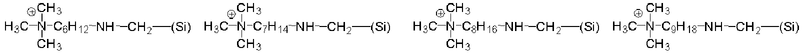

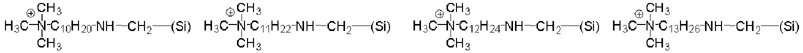

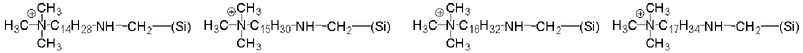

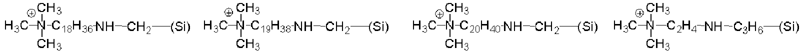

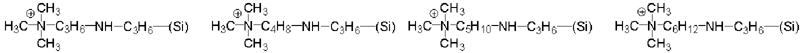

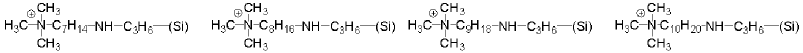

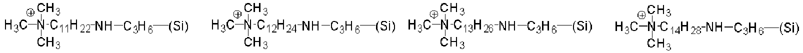

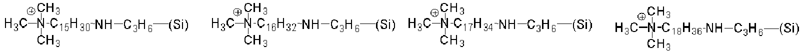

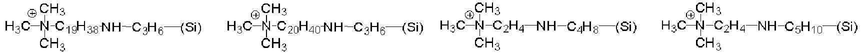

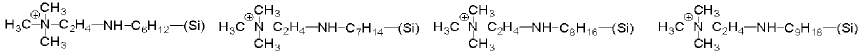

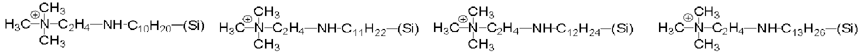

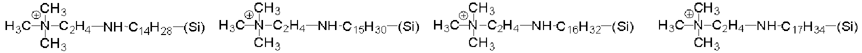

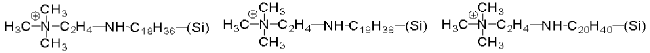

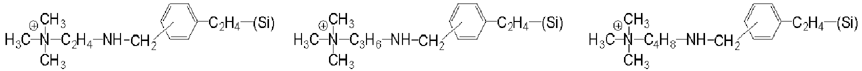

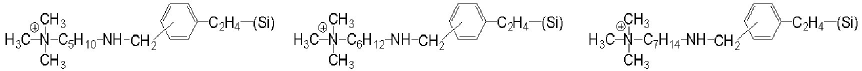

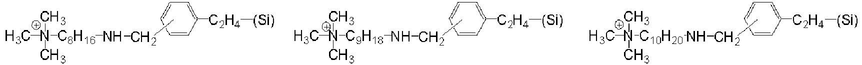

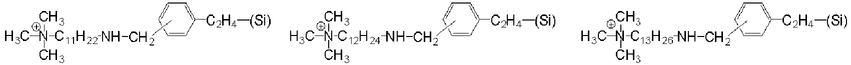

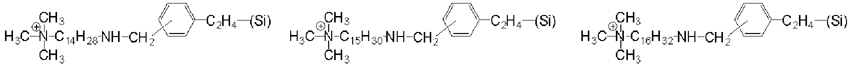

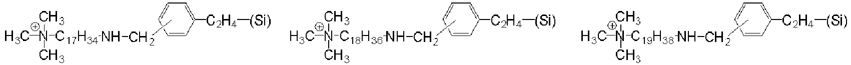

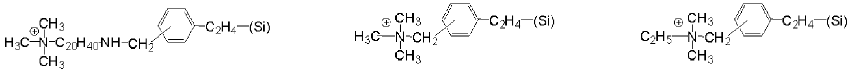

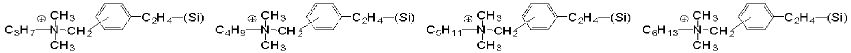

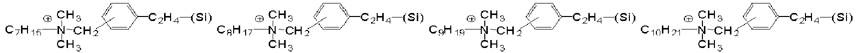

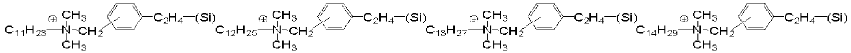

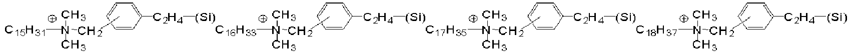

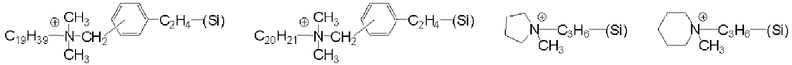

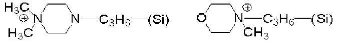

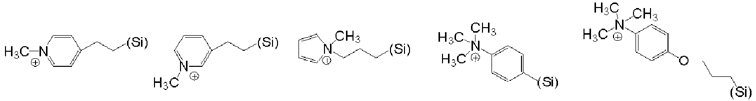

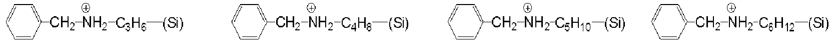

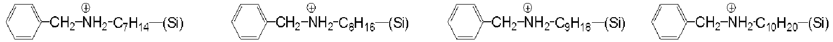

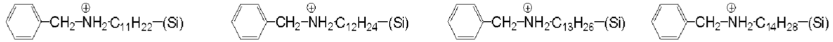

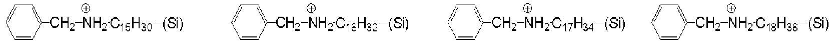

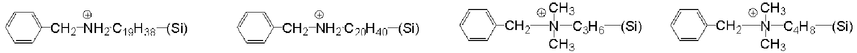

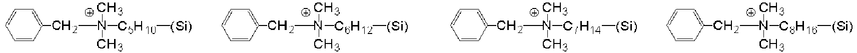

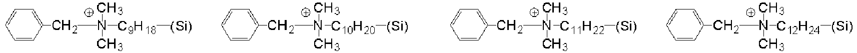

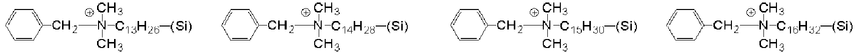

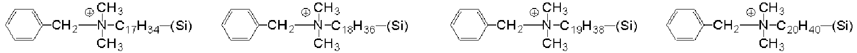

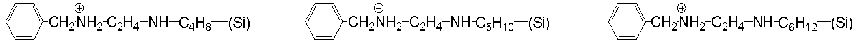

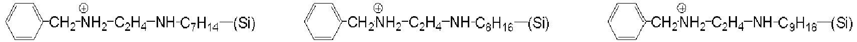

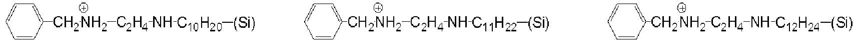

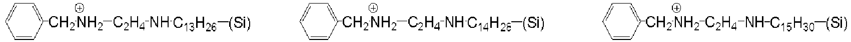

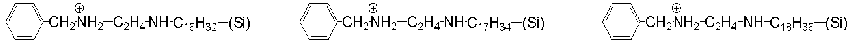

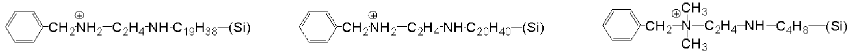

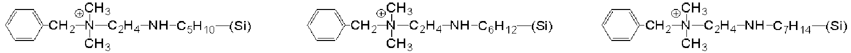

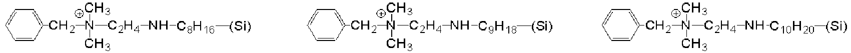

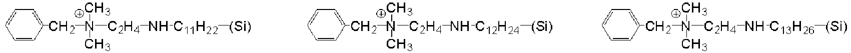

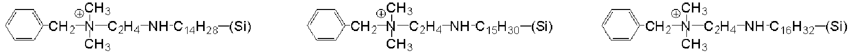

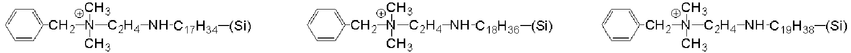

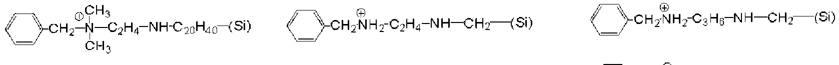

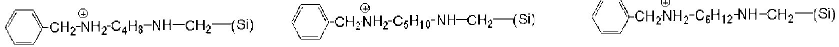

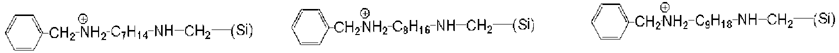

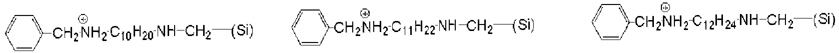

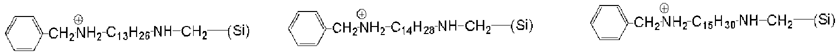

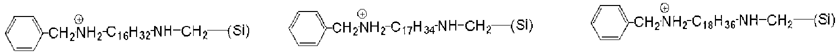

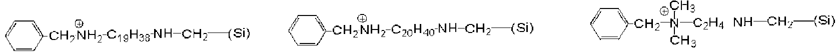

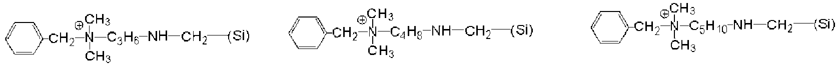

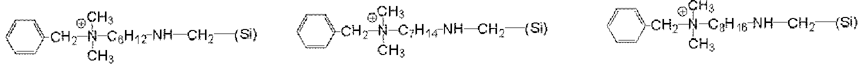

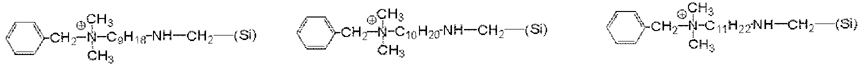

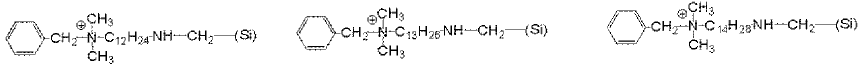

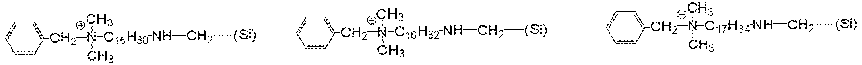

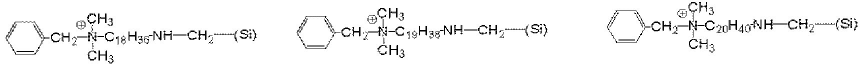

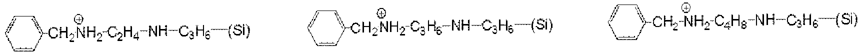

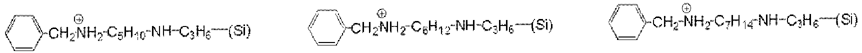

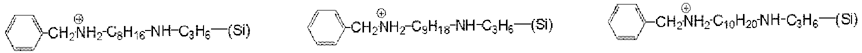

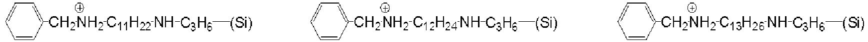

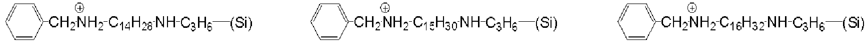

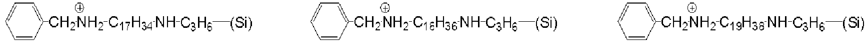

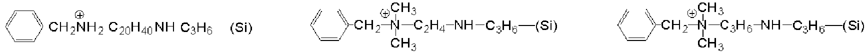

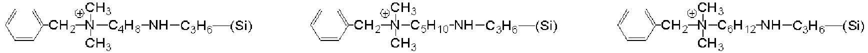

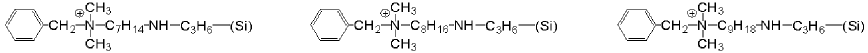

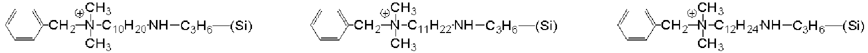

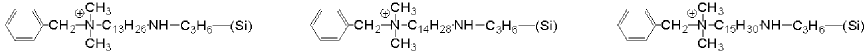

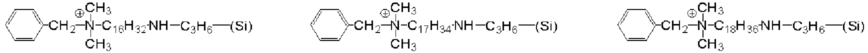

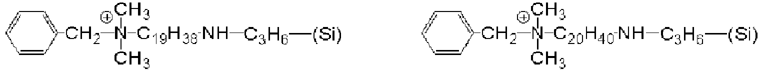

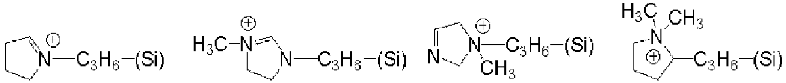

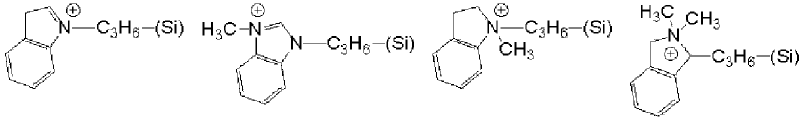

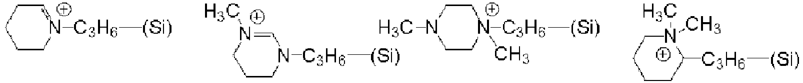

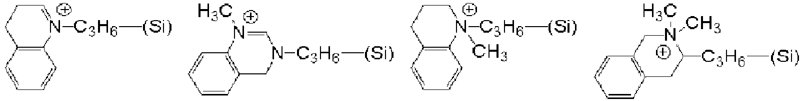

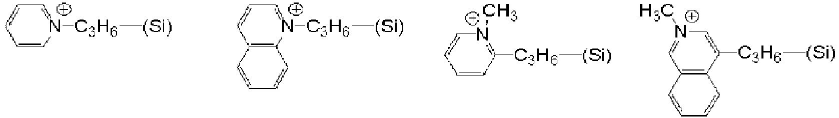

As a hydrolyzable silicon compound used simultaneously with (Xm-1), (Xm-2), (Xm-3), and (Xm-4) above to produce (Xc-10), the above hydrolyzable monomer (Sm) can be examplified. In addition, a hydrolyzable metallic compound (Mm), which is represented by the above formula (Mm), may be added.

One or more of the monomers (Xm-1), (Xm-2), (Xm-3), and (Xm-4), one or more of (Sm), and if necessary one or more of (Mm), which are selected and mixed before or during the reaction, may be a reaction raw material for forming (Xc-10). The reaction conditions may be the same as the synthesis method for thermally crosslinkable polysiloxane (Sx).

The molecular weight of the resulting crosslinking catalyst (Xc-10) can be adjusted by controlling reaction conditions during polymerization as well as monomer selection. However, if the weight-average molecular weight is 100,000 or less, no undesired substance is generated and no coating spots occur, so that the molecular weight used is preferably 100,000 or less, more preferably 200 to 50,000, and still more preferably 300 to 30,000. Note that the weight average molecular weight data above, is expressed in terms of polystyrene by gel permeation chromatography (GPC) using RI as a detector and tetrahydrofuran as an eluent, and polystyrene as a standard.

One of the above crosslinking catalysts (Xc-1), (Xc-2), (Xc-3), (Xc-4), and (Xc-10) may be used alone or two or more thereof may be used in combination. The amount of crosslinking catalyst is preferably 0.01 to 50 parts by mass and more preferably 0.1 to 40 parts by mass based on 100 parts by mass of base polymer (thermally crosslinkable polysiloxane (Sx) obtained by the above method).

### (Organic acid)

In order to improve the stability of the composition for forming a silicon-containing resist film according to the present invention, it is preferable to add a monovalent or multivalent or higher organic acid having 1 to 30 carbon atoms. Examples of the acid added at this time include formic acid, acetic acid, propionic acid, butanoic acid, pentanoic acid, hexanoic acid, heptanoic acid, octanoic acid, nonanoic acid, decanoic acid, oleic acid, stearic acid, linoleic acid, linolenic acid, benzoic acid, phthalic acid, isophthalic acid, terephthalic acid, salicylic acid, trifluoroacetic acid, monochloroacetic acid, dichloroacetic acid, trichloroacetic acid, oxalic acid, malonic acid, methylmalonic acid, ethylmalonic acid, propylmalonic acid, butylmalonic acid, dimethylmalonic acid, diethylmalonic acid, succinic acid, methylsuccinic acid, glutaric acid, adipic acid, itaconic acid, maleic acid, fumaric acid, citraconic acid, and citric acid. Particularly preferred is, for instance, oxalic acid, maleic acid, formic acid, acetic acid, propionic acid, or citric acid. To maintain stability, a mixture of two or more acids may also be used. The amount of organic acid added is preferably 0.001 to 25 parts by mass, more preferably 0.01 to 15 parts by mass, and still more preferably 0.1 to 5 parts by mass based on 100 parts by mass of silicon contained in the composition for forming a silicon-containing resist film according to the present invention.

Alternatively, the above organic acid may be added so that the pH of the composition for forming a silicon-containing resist film according to the present invention is preferably 0 ≤ pH ≤ 7, more preferably 0.3 ≤ pH ≤ 6.5, and still more preferably 0.5 ≤ pH ≤ 6.

### (Water)

In the present invention, water may be added to the composition for forming a silicon-containing resist film. By the addition of water, the polysiloxane compound in the composition for forming a silicon-containing resist film according to the present invention is hydrated, thus improving the lithographic performance. The content of water in the solvent component of the composition for forming a silicon-containing resist film according to the present invention is preferably more than 0 mass% and less than 50 mass%, especially preferably 0.3 to 30 mass%, and still more preferably 0.5 to 20 mass%. If the amount of water added is less than 50 mass%, the uniformity of the silicon-containing resist film becomes favorable and no cissing occurs. On the other hand, if the amount of water added exceeds 0 mass%, the lithographic performance is good.

The amount of all solvents, including water, used is preferably 100 to 100,000 parts by mass, especially preferably 200 to 50,000 parts by mass based on 100 parts by mass of thermally crosslinkable polysiloxane which is the base polymer.

### (Stabilizer)

A stabilizer further may be added to the composition for forming a silicon-containing resist film according to the present invention. Monovalent or multivalent or higher alcohol with a cyclic ether as a substituent may be added as the stabilizer. In particular, the addition of each stabilizer described in paragraphs [0181] to [0182] of JP 2009-126940 A can improve the stability of the composition for forming a silicon-containing resist film. The amount of stabilizer added is preferably 0 to 50 parts by mass and more preferably 0 to 40 parts by mass based on 100 parts by mass of thermally crosslinkable polysiloxane (Sx) which is the base polymer.

### (Surfactant)

The composition for forming a silicon-containing resist film according to the present invention may further be added with a surfactant. As such, specifically, the material described in paragraph [0185] of JP 2009-126940 A may be added. The amount of surfactant added is preferably 0 to 10 parts by mass and more preferably 0 to 5 parts by mass based on 100 parts by mass of thermally crosslinkable polysiloxane (Sx), the base polymer.

### (High-boiling-point solvent)

Further, in the present invention, it is also possible to add a high-boiling-point solvent with a boiling point of 180°C or higher to the composition as needed. Examples of this high-boiling-point solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, γ-butyrolactone, tripropylene glycol monomethyl ether, diacetone alcohol, n-nonyl acetate, ethylene glycol monoethyl ether acetate, 1,2-diacetoxyethane, 1-acetoxy-2-methoxyethane, 1,2-diacetoxypropane, diethylene glycol monomethyl ether acetate, diethylene glycol monoethyl ether acetate, diethylene glycol mono-n-butyl ether acetate, propylene glycol monomethyl ether acetate, propylene glycol monopropyl ether acetate, propylene glycol monobutyl ether acetate, dipropylene glycol monomethyl ether acetate, and dipropylene glycol monoethyl ether acetate. The amount of high-boiling-point solvent added, as the proportion in the solvent component is preferably 0 to 20 mass% and more preferably 0 to 10 mass%.

### [Patterning process]

One of the patterning processes of the present invention is a patterning process (what is called "multilayer resist method") comprising the steps of:
forming, on a body to be processed, an organic film using a coating-type organic film material;
forming, on the organic film, a silicon-containing resist middle layer film using the above composition for forming a silicon-containing resist film;
forming, on the silicon-containing resist middle layer film, a resist upper layer film by using a resist upper layer film material comprising a photoresist composition;
forming a circuit pattern on the resist upper layer film;
using, as a mask, the resist upper layer film having the formed circuit pattern to transfer the pattern onto the silicon-containing resist middle layer film by etching;
using, as a mask, the silicon-containing resist middle layer film having the transferred pattern to transfer the pattern onto the organic film by etching; and
using, as a mask, the organic film having the transferred pattern to transfer the pattern onto the body to be processed by etching.

One of the patterning processes of the present invention is a patterning process comprising the steps of:
forming, on a body to be processed by CVD method, a hard mask primarily composed of carbon;
forming, on the hard mask, a silicon-containing resist middle layer film using the above composition for forming a silicon-containing resist film;
forming, on the silicon-containing resist middle layer film, a resist upper layer film by using a resist upper layer film material comprising a photoresist composition;
forming a circuit pattern on the resist upper layer film;
using, as a mask, the resist upper layer film having the formed circuit pattern to transfer the pattern onto the silicon-containing resist middle layer film by etching;
using, as a mask, the silicon-containing resist middle layer film having the transferred pattern to transfer the pattern onto the hard mask by dry etching; and
using, as a mask, the hard mask having the transferred pattern to transfer the pattern onto the body to be processed by dry etching.

The above patterning processes are particularly practical for forming fine patterns because they suppress pattern collapse of the resist upper layer film, they are excellent in pattern transfer to the silicon-containing resist middle layer film by dry etching, and defects due to residues are hardly generated because the silicon-containing resist middle layer film remaining after the patterning is finished is easily removed.

One of the patterning processes of the present invention is a patterning process of forming a pattern on a body to be processed, the process comprising the steps of:
forming, on a body to be processed, a silicon-containing resist middle layer film using the above composition for forming a silicon-containing resist film;
forming, on the silicon-containing resist middle layer film, a resist upper layer film by using a resist upper layer film material comprising a photoresist composition;
forming a circuit pattern on the resist upper layer film;
using, as a mask, the resist upper layer film having the formed circuit pattern to transfer the pattern onto the silicon-containing resist middle layer film by etching; and
using, as a mask, the silicon-containing resist middle layer film having the transferred pattern to transfer the pattern onto the body to be processed by dry etching.

In the positive patterning process, after forming a photoresist film (resist upper layer film) and heat treatment, exposure is performed and alkaline development is performed using a general alkaline developer to obtain a positive resist pattern. Post-exposure baking (PEB) is also preferably performed after exposure.

It is possible to use, for instance, a tetramethylammonium hydroxide (TMAH) aqueous solution as the alkaline developer above.

The method of forming a circuit pattern on the above resist upper layer film is preferably a patterning process using optical lithography with a wavelength of 10 nm or more and 300 nm or less, direct electron beam lithography, nanoimprinting, or a combination thereof.

Such a method of forming a circuit pattern on the resist upper layer film will more fully produce the effects of the present invention.

The body to be processed used is preferably a semiconductor device substrate or the semiconductor device substrate on which any of a metal film, a metal carbide film, a metal oxide film, a metal nitride film, a metal oxide carbide film, or a metal nitride film is deposited.

When the above specific material is used as the body to be processed above, the effect of the present invention is more fully produced.

As the above metal, it is preferable to use silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

When the above specific metal is used as the metal constituting the body to be processed above, the effect of the present invention is more fully produced.

### EXAMPLES

Hereinafter, the present invention will be described in detail with reference to Synthesis Examples, Comparative Synthesis Examples, Examples, and Comparative Examples. However, the present invention is not limited to these descriptions. Note that in the following examples, % represents mass%, and the molecular weight Mw is the weight-average molecular weight in terms of polystyrene, as measured by GPC using tetrahydrofuran as an eluent.

In addition, "Me" stands for methyl group, "Et" for ethyl group, "Bu" for butyl group, and "Ph" for phenyl group.

### [Synthesis Example 1 (To synthesize compound 1)]

A mixture of 16.4 g of compound (101), 22.8 g of compound (102), and 5.1 g of compound (110) (molar ratio: 40/50/10) was added to a mixture of 75.6 g of deionized water and 0.5 g of 7% nitric acid and the resulting mixture was kept at 25°C for 24 hours for hydrolytic condensation. After the reaction was completed, 450 g of propylene glycol ethyl ether (PGEE) and 1.0 g of 24% maleic acid aqueous solution were added, and the water used and by-product alcohol during hydrolytic condensation were distilled away under reduced pressure to afford 240 g of PGEE solution containing a thermally crosslinkable polysiloxane compound 1 (compound concentration: 10%). The polystyrene equivalent molecular weight of thermally crosslinkable polysiloxane compound 1 was measured to be Mw = 2,600.

Compounds 2 to 18 were synthesized using the monomers listed in Table 1 under the same conditions as in Synthesis Example 1 (Synthesis Examples 2 to 18).

**[Table 1]**

| | Amount (mol%) of each monomer added | | | | | | | | | | | Mw |
|---|---|---|---|---|---|---|---|---|---|---|---|---|
| Synthesis Example | 100 | 101 | 102 | 110 | 111 | 112 | 113 | 114 | 115 | 116 | 117 | |
| 1 | - | 40 | 50 | 10 | - | - | - | - | - | - | - | 2600 |
| 2 | - | 40 | 50 | - | 10 | - | - | - | - | - | - | 2700 |
| 3 | - | 40 | 50 | - | - | 10 | - | - | - | - | - | 2800 |
| 4 | - | 40 | 50 | - | - | - | 10 | - | - | - | - | 2800 |
| 5 | - | 40 | 50 | - | - | - | - | 10 | - | - | - | 2700 |
| 6 | - | 40 | 50 | - | - | - | - | - | 10 | - | - | 2900 |
| 7 | - | 40 | 50 | - | - | - | - | - | - | 10 | - | 2700 |
| 8 | - | 40 | 50 | - | - | - | - | - | - | - | 10 | 2700 |
| 9 | - | 20 | 70 | 10 | - | - | - | - | - | - | - | 2500 |
| 10 | - | 20 | 70 | - | 5 | 5 | - | - | - | - | - | 2700 |
| 11 | - | 20 | 70 | - | - | - | 10 | - | - | - | - | 2500 |
| 12 | - | 20 | 70 | - | - | - | - | 5 | 5 | - | - | 2800 |
| 13 | - | 20 | 70 | - | - | - | - | - | - | 10 | - | 2100 |
| 14 | - | 20 | 70 | - | - | - | - | 5 | - | - | 5 | 2500 |
| 15 | - | 20 | 70 | 5 | - | 5 | - | - | - | - | - | 2300 |
| 16 | - | 20 | 70 | - | - | - | 5 | - | - | 5 | - | 2300 |
| 17 | 5 | 20 | 70 | - | 5 | - | - | - | - | - | - | 2300 |
| 18 | 5 | 20 | 70 | - | - | - | 5 | - | - | - | - | 2600 |

### [Comparative Synthesis Examples]

Polysiloxane compounds R1 and R2 for comparison were synthesized under the same conditions as in Synthesis Example 1 while using the monomers shown in Table 2 (Comparative Synthesis Examples 1 to 2).

**[Table 2]**

| | Amount (mol%) of each monomer added | | | | | | | | | | | Mw |
|---|---|---|---|---|---|---|---|---|---|---|---|---|
| Comparative Synthesis Example | 100 | 101 | 102 | 110 | 111 | 112 | 113 | 114 | 115 | 116 | 117 | |
| R1 | 5 | 45 | 50 | - | - | - | - | - | - | - | - | 2500 |
| R2 | 10 | 20 | 70 | - | - | - | - | - | - | - | - | 2300 |

PhSi(OCH₃)₃ ... Compound (100)

CH₃Si(OCH₃)₃ ... Compound (101)

Si(OCH₃)₄ ... Compound (102)

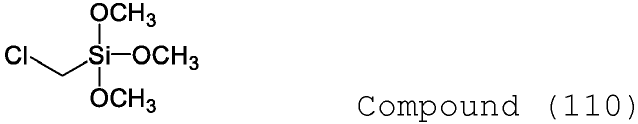

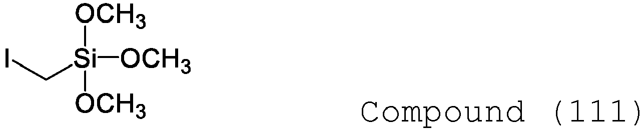

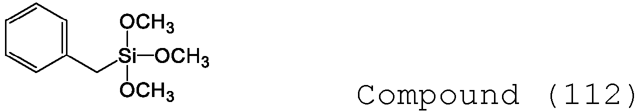

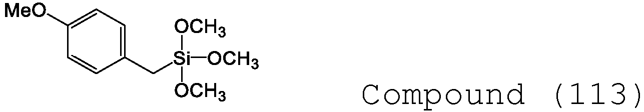

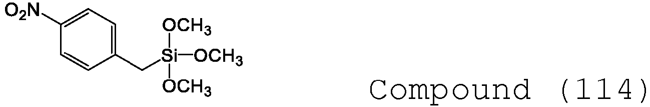

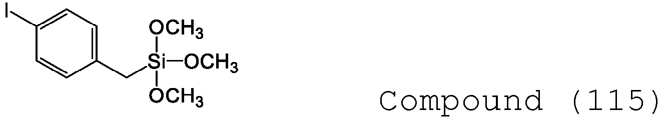

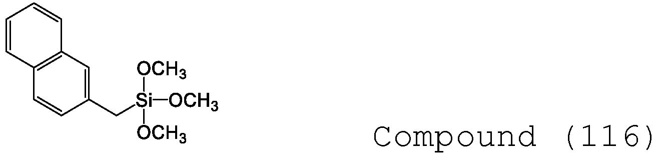

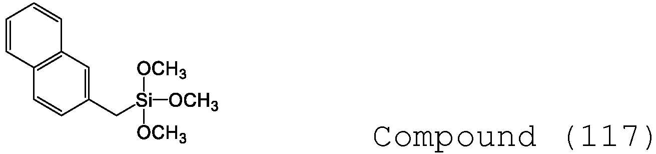

### [Examples and Comparative Examples]

The thermally crosslinkable polysiloxane compounds 1 to 18 of the present invention synthesized in the above Synthesis Examples, the comparative polysiloxane compounds R1 and R2 synthesized in the above Comparative Synthetic Examples, and the crosslinking catalyst, acid, photoacid generator, solvent, and water were mixed in the proportions shown in Tables 3 and 4. Each mixture was filtered through a 0.1 µm fluororesin filter to prepare, as Sol. 1 to Sol. 30, each solution of a composition for forming a silicon-containing film.

**[Table 3]**

| No. | Polysiloxane (parts by mass) | Crosslinking catalyst (parts by mass) | Photoacid generator (parts by mass) | Acid (parts by mass) | Solvent (parts by mass) | Water (parts by mass) |
|---|---|---|---|---|---|---|
| Sol. 1 | Compound 1 (1) | XL-1 (0.03) | None | Maleic acid (0.01) | PGEE (100) | Water (10) |
| Sol. 2 | Compound 2 (1) | XL-2 (0.03) | None | Maleic acid (0.01) | PGEE (100) | Water (10) |
| Sol. 3 | Compound 3 (1) | XL-3 (0.03) | None | Maleic acid (0.01) | PGEE (100) | Water (10) |
| Sol. 4 | Compound 4 (1) | XL-1 (0.03) | None | Maleic acid (0.01) | PGEE (100) | Water (10) |
| Sol. 5 | Compound 5 (1) | XL-2 (0.03) | None | Maleic acid (0.01) | PGEE (100) | Water (10) |
| Sol. 6 | Compound 6 (1) | XL-3 (0.03) | None | Maleic acid (0.01) | PGEE (100) | Water (10) |
| Sol. 7 | Compound 7 (1) | XL-1 (0.03) | None | Maleic acid (0.01) | PGEE (100) | Water (10) |
| Sol. 8 | Compound 8 (1) | XL-2 (0.03) | None | Maleic acid (0.01) | PGEE (100) | Water (10) |
| Sol. 9 | Compound 9 (1) | XL-3 (0.03) | None | Maleic acid (0.01) | PGEE (100) | Water (10) |
| Sol. 10 | Compound 10 (1) | XL-1 (0.03) | None | Maleic acid (0.01) | PGEE (100) | Water (10) |
| Sol. 11 | Compound 11 (1) | XL-2 (0.03) | None | Maleic acid (0.01) | PGEE (100) | Water (10) |
| Sol. 12 | Compound 12 (1) | XL-3 (0.03) | None | Maleic acid (0.01) | PGEE (100) | Water (10) |
| Sol. 13 | Compound 13 (1) | XL-1 (0.03) | None | Maleic acid (0.01) | PGEE (100) | Water (10) |
| Sol. 14 | Compound 14 (1) | XL-2 (0.03) | None | Maleic acid (0.01) | PGEE (100) | Water (10) |
| Sol. 15 | Compound 15 (1) | XL-3 (0.03) | None | Maleic acid (0.01) | PGEE (100) | Water (10) |
| Sol. 16 | Compound 16 (1) | XL-1 (0.03) | None | Maleic acid (0.01) | PGEE (100) | Water (10) |
| Sol. 17 | Compound 17 (1) | XL-2 (0.03) | None | Maleic acid (0.01) | PGEE (100) | Water (10) |
| Sol. 18 | Compound 18 (1) | XL-3 (0.03) | None | Maleic acid (0.01) | PGEE (100) | Water (10) |
| Sol. 19 | Compound 1 (1) | XL-1 (0.03) | PAG-1 (0.01) | Maleic acid (0.01) | PGEE (100) | Water (10) |
| Sol. 20 | Compound 2 (1) | XL-2 (0.03) | PAG-2 (0.01) | Maleic acid (0.01) | PGEE (100) | Water (10) |

**[Table 4]**

| No. | Polysiloxane (parts by mass) | Crosslinking catalyst (parts by mass) | Photoacid generator (parts by mass) | Acid (parts by mass) | Solvent (parts by mass) | Water (parts by mass) |
|---|---|---|---|---|---|---|
| Sol. 21 | Compound 3 (1) | XL-3 (0.03) | PAG-3 (0.01) | Maleic acid (0.01) | PGEE (100) | Water (10) |
| Sol. 22 | Compound 4 (1) | XL-1 (0.03) | PAG-4 (0.01) | Maleic acid (0.01) | PGEE (100) | Water (10) |
| Sol. 23 | Compound 5 (1) | XL-2 (0.03) | PAG-5 (0.01) | Maleic acid (0.01) | PGEE (100) | Water (10) |
| Sol. 24 | Compound 6 (1) | XL-3 (0.03) | PAG-6 (0.01) | Maleic acid (0.01) | PGEE (100) | Water (10) |
| Sol. 25 | Compound 7 (1) | XL-1 (0.03) | PAG-7 (0.01) | Maleic acid (0.01) | PGEE (100) | Water (10) |
| Sol. 26 | Compound 8 (1) | XL-2 (0.03) | None | Maleic acid (0.01) | PGEE (90) | Water (10) |
| | | | | | GBL (10) | |
| Sol. 27 | Compound 9 (1) | XL-3 (0.03) | None | Maleic acid (0.01) | PGEE (90) | Water (10) |
| | | | | | DAA (10) | |
| Sol. 28 | Compound 10 (1) | XL-1 (0.03) | None | Maleic acid (0.01) | PGEE (90) | Water (10) |
| | | | | | PGME (10) | |
| Sol. 29 | Compound R1 (1) | XL-2 (0.03) | None | Maleic acid (0.01) | PGEE (100) | Water (10) |
| Sol. 30 | Compound R2 (1) | XL-3 (0.03) | None | Maleic acid (0.01) | PGEE (100) | Water (10) |

The crosslinking catalysts used were as follows.
XL-1 ... Triphenylsulfonium nitrate
XL-2 ... Tetramethylammonium nitrate
XL-3 ... Tetraoctylammonium nitrate

The solvents used were as follows.
PGEE ... Propylene glycol monoethyl ether
PGME ... Propylene glycol monomethyl ether
GBL ... γ-Butyllactone
DAA ... Diacetone alcohol

**[Table 5]**

| PAG | | PAG | |
|---|---|---|---|
| 1 | 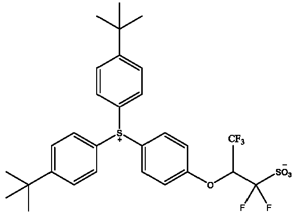 | 5 | 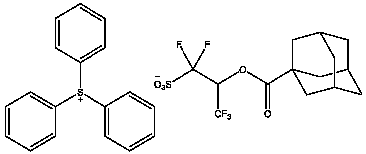 |
| 2 | 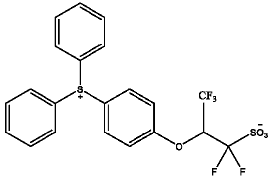 | 6 | 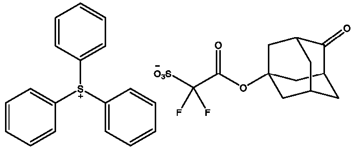 |
| 3 | 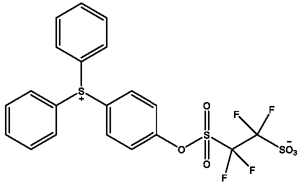 | 7 | 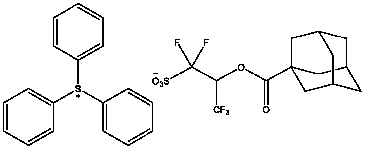 |
| 4 | 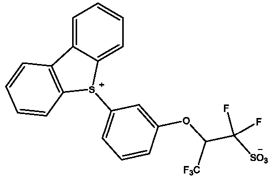 | | |

### [Examples 1-1 to 1-28 and Comparative Examples 1-1 to 1-2]

### (EUV patterning test)

Sol. 1 to Sol. 30 which are the composition for forming a silicon-containing resist film, were each spin-coated on a silicon wafer and heated at 220°C for 60 seconds to produce a silicon-containing resist film, namely Film 1 to Film 30, with a film thickness of 25 nm.

Then, a resist material obtained by dissolving the following components in the proportions shown in Table 6 was spin-coated onto the corresponding Films 1 to 30, and pre-baked at 105°C for 60 seconds using a hot plate to produce a resist upper layer film with a film thickness of 60 nm. The resultant was exposed using ASML's EUV scanner NXE3300 (NA0.33, σ0.9/0.6, quadrupole illumination, mask with a hole pattern of +20% bias and a pitch of 46 nm on the wafer). PEB was performed on a hot plate at 100°C for 60 seconds and developed with 2.38 mass% TMAH aqueous solution for 30 seconds to obtain a hole pattern with a dimension of 23 nm.

Using a length measuring SEM (CG5000) manufactured by Hitachi High-Technologies Corporation, the exposure when a hole size of 23 nm was formed was measured and used as the sensitivity. In addition, the dimensions of 50 holes were measured at this time and the dimensional variation (CDU, 3σ) was determined. Table 7 shows the results.

The polymers, quenchers, sensitizers, surfactants, and organic solvents used as resist materials are listed below. 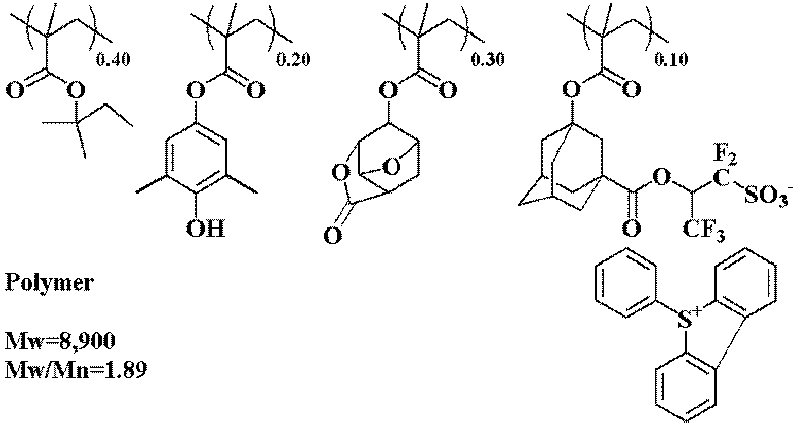 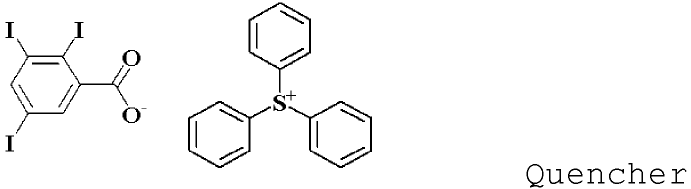 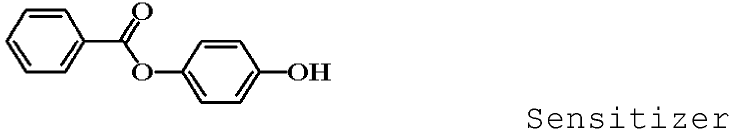
Surfactant: FC-4430 manufactured by 3M Company
PGMEA: Propylene glycol monomethyl ether acetate
CyHO: Cyclohexanone
PGME: Propylene glycol monomethyl ether

**[Table 6]**

| Component | Polymer | Quencher | Sensitizer | Surfactant | Organic solvent |
|---|---|---|---|---|---|
| Composition (parts by mass) | (100) | (4.0) | (2.1) | (0.25) | PGMEA (400) |
| | | | | | CyHO (2000) |
| | | | | | PGME (100) |

### (Silicon-containing resist film etching test)

Sol. 1 to Sol. 30 which is the composition for forming a silicon-containing resist film, were each spin-coated on a silicon wafer and heated at 220°C for 60 seconds to produce a silicon-containing resist middle layer film, namely Film 1 to Film 30, with a film thickness of 25 nm.

Etching tests were performed on these silicon-containing resist middle layer films under the following etching conditions.

### Etching test with CHF₃/CF₄ gas

Apparatus: Dry etching apparatus Telius SP, manufactured by Tokyo Electron Limited.

### Etching test:

| | |
|---|---|
| Chamber pressure | 10 Pa |
| Upper/Lower RF power | 200W/100W |
| CHF₃ gas flow rate | 50 ml/min |
| CF₄ gas flow rate | 50 ml/min |
| N₂ gas flow rate | 100 ml/min |
| Processing time | 20 sec |

**[Table 7]**

| | Silicon-containing resist lower layer film | Sensitivity (mJ/cm²) | CDU (nm) | CHF₃/CF₄ gas dry etching rate (nm/min) |
|---|---|---|---|---|
| Example 1-1 | Film 1 | 28 | 2.1 | 49.4 |
| Example 1-2 | Film 2 | 30 | 2.1 | 49.5 |
| Example 1-3 | Film 3 | 30 | 2.1 | 51.7 |
| Example 1-4 | Film 4 | 30 | 2.2 | 51.9 |
| Example 1-5 | Film 5 | 29 | 2.2 | 48.9 |
| Example 1-6 | Film 6 | 30 | 2.0 | 51.3 |
| Example 1-7 | Film 7 | 29 | 2.1 | 49.6 |
| Example 1-8 | Film 8 | 28 | 2.1 | 50.8 |
| Example 1-9 | Film 9 | 30 | 2.0 | 48.6 |
| Example 1-10 | Film 10 | 29 | 2.0 | 49.2 |
| Example 1-11 | Film 11 | 28 | 2.1 | 48.3 |
| Example 1-12 | Film 12 | 28 | 2.1 | 51.6 |
| Example 1-13 | Film 13 | 30 | 2.0 | 48.6 |
| Example 1-14 | Film 14 | 28 | 2.0 | 50.9 |
| Example 1-15 | Film 15 | 30 | 2.1 | 52.0 |
| Example 1-16 | Film 16 | 28 | 2.1 | 48.9 |
| Example 1-17 | Film 17 | 30 | 2.1 | 48.6 |
| Example 1-18 | Film 18 | 30 | 2.1 | 51.9 |
| Example 1-19 | Film 19 | 27 | 2.2 | 50.3 |
| Example 1-20 | Film 20 | 29 | 2.1 | 51.4 |
| Example 1-21 | Film 21 | 29 | 2.1 | 50.6 |
| Example 1-22 | Film 22 | 29 | 2.0 | 49.0 |
| Example 1-23 | Film 23 | 28 | 2.0 | 49.1 |
| Example 1-24 | Film 24 | 29 | 2.2 | 48.5 |
| Example 1-25 | Film 25 | 28 | 2.0 | 51.3 |
| Example 1-26 | Film 26 | 29 | 2.1 | 50.5 |
| Example 1-27 | Film 27 | 28 | 2.1 | 50.0 |
| Example 1-28 | Film 28 | 30 | 2.2 | 50.7 |
| Comparison Example 1-1 | Film 29 | 28 | 2.5 | 46.1 |
| Comparison Example 1-2 | Film 30 | 28 | 2.5 | 47.1 |

As shown in Comparative Examples 1-1 to 1-2 in Table 7, it was found that Films 29 to 30 without any polysiloxane containing the specific substructure in the present invention had an inferior CDU value or had an insufficient etching rate. By contrast, as shown in Examples 1-1 to 1-28, Films 1 to 28 using the polysiloxane containing the specific substructure in the present invention were found to exert CDU improvement effects and had sufficient etching rates. This may be due to the fact that the heat treatment caused a elimination reaction of specific substituents, and formation of a strong film with a high Si ratio. In addition, Films 19 to 25 with a photoacid generator have been found to be more sensitive than the corresponding Films 1 to 7 without any photoacid generator.

### [Examples 2-1 to 2-28 and Comparative Examples 2-1 to 2-2]

### (ArF patterning test)

A spin-on carbon film ODL-102 (carbon content: 89 mass%), manufactured by Shin-Etsu Chemical Co., Ltd., with a film thickness of 200 nm was formed on a silicon wafer. Sol. 1 to Sol. 30 which is the composition for forming a silicon-containing resist film, were each applied onto the spin-on carbon film and heated at 220°C for 60 seconds to produce a silicon-containing resist middle layer film, namely Film 1 to Film 30, with a film thickness of 20 nm.

Then, ArF resist solution for positive development (PR-1) as described in Table 8 was applied onto the above silicon-containing resist film, and baked at 110°C for 60 seconds to form a photoresist film with a film thickness of 100 nm. The immersion protective film material (TC-1) described in Table 9 was applied onto the photoresist film and baked at 90°C for 60 seconds to form a protective film with a film thickness of 50 nm.

These were then each exposed with an ArF immersion lithography apparatus (manufactured by ASML; XT-1900i, NA1.35, σ0.97/0.77, 35° dipole polarized illumination), baked at 100°C for 60 seconds (PEB), and developed with 2.38 mass% tetramethylammonium hydroxide (TMAH) aqueous solution for 30 seconds to obtain a 40-nm 1:1 positive line-and-space pattern. The LWR of this dimension was inspected using an electron microscope (CG5000), manufactured by Hitachi High-Technologies Corporation. Table 10 shows the results.

**[Table 8]**

| No. | Polymer (parts by mass) | Acid generator (parts by mass) | Base (parts by mass) | Surfactant (parts by mass) | Solvent (parts by mass) |
|---|---|---|---|---|---|
| PR-1 | ArF Resist polymer 1 (100) | PAG-A (7.0) | Quencher (1.0) | FC-4430 (0.2) | PGMEA (2.500) |

ArF resist polymer 1 [molecular weight (Mw) = 7,800; degree of dispersion (Mw/Mn) = 1.78]: 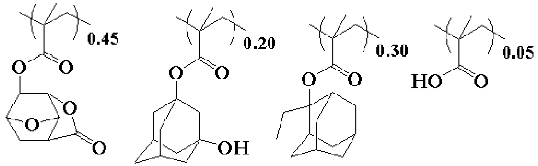
Acid generator: PAG-A 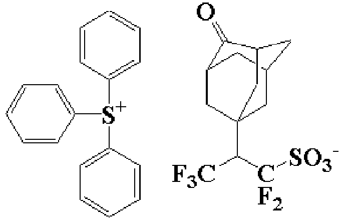
Base: Quencher 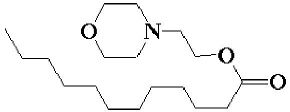
Surfactant: FC-4430 manufactured by 3M Company

**[Table 9]**

| | Polymer (parts by mass) | Organic solvent (parts by mass) |
|---|---|---|
| TC-1 | Protective film polymer (100) | Diisoamyl ether (2700) |
| | | 2-Methyl-1-butanol (270) |

Protective film polymer [molecular weight (Mw) = 8,800; degree of dispersion (Mw/Mn) = 1.69]

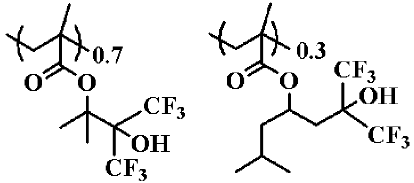

**[Table 10]**

| | Silicon-containing resist lower layer film | LWR |
|---|---|---|
| Example 2-1 | Film 1 | 2.0 |
| Example 2-2 | Film 2 | 2.1 |
| Example 2-3 | Film 3 | 2.2 |
| Example 2-4 | Film 4 | 2.1 |
| Example 2-5 | Film 5 | 2.0 |
| Example 2-6 | Film 6 | 2.1 |
| Example 2-7 | Film 7 | 2.0 |
| Example 2-8 | Film 8 | 2.1 |
| Example 2-9 | Film 9 | 2.2 |
| Example 2-10 | Film 10 | 2.0 |
| Example 2-11 | Film 11 | 2.0 |
| Example 2-12 | Film 12 | 2.0 |
| Example 2-13 | Film 13 | 2.0 |
| Example 2-14 | Film 14 | 2.1 |
| Example 2-15 | Film 15 | 2.2 |
| Example 2-16 | Film 16 | 2.2 |
| Example 2-17 | Film 17 | 2.1 |
| Example 2-18 | Film 18 | 2.1 |
| Example 2-19 | Film 19 | 2.1 |
| Example 2-20 | Film 20 | 2.1 |
| Example 2-21 | Film 21 | 2.1 |
| Example 2-22 | Film 22 | 2.0 |
| Example 2-23 | Film 23 | 2.2 |
| Example 2-24 | Film 24 | 2.2 |
| Example 2-25 | Film 25 | 2.2 |
| Example 2-26 | Film 26 | 2.1 |
| Example 2-27 | Film 27 | 2.1 |
| Example 2-28 | Film 28 | 2.0 |
| Comparison Example 1-1 | Film 29 | 2.6 |
| Comparison Example 1-2 | Film 30 | 2.5 |

As shown in Examples 2-1 to 2-28 of Table 10, Films 1 to 28 using the polysiloxane containing the specific substructure in the present invention were found to exert LWR improvement effects. By contrast, as shown in Comparative Examples 2-1 to 2-2, Films 29 to 30 without any polysiloxane containing the specific substructure had inferior LWR. This may be due to the fact that in Examples 2-1 to 2-28, the heat treatment caused a elimination reaction of specific substituents and a strong film with a high Si ratio was formed which suppressed the diffusion into the upper layer resist.

The present description includes the following inventions.
[1] A composition for forming a silicon-containing resist film comprising a polysiloxane comprising at least one of any of a repeating unit represented by formula (A-1), a repeating unit represented by formula (A-2), or a substructure represented by formula (A-3): 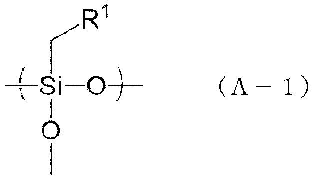 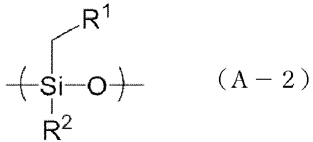 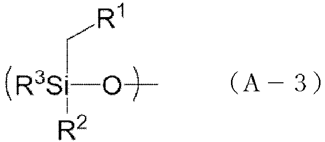 wherein R¹ is a monovalent organic group having 1 to 30 carbon atoms and optionally having a substituent, a halogen atom, a hydroxy group, a sulfo group, a nitro group, or a carboxyl group, functioning as a group eliminated by heat, acid, or base, and R² and R³ each independently represent a monovalent organic group having 1 to 30 carbon atoms and optionally having a substituent.
[2] The composition for forming a silicon-containing resist film according to [1], wherein R¹ in the formula (A-1), (A-2), or (A-3) is a monovalent group represented by formula (B-1), a halogen atom, a hydroxy group, a sulfo group, a nitro group, or a carboxyl group, functioning as a group eliminated by heat, acid, or base, 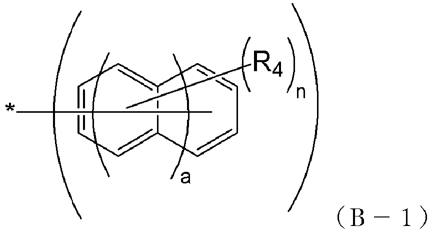 wherein R⁴ are each a substituent attached to an aromatic ring and each independently represent a hydrogen atom or an alkyl group having 1 to 20 carbon atoms and optionally having a substituent, an aryl group having 6 to 20 carbon atoms and optionally having a substituent, a halogenated alkyl group having 1 to 20 carbon atoms and optionally having a substituent, a halogenated aryl group having 6 to 20 carbon atoms and optionally having a substituent, an alkoxyalkyl group having 1 to 20 carbon atoms and optionally having a substituent, an alkoxyaryl group having 6 to 20 carbon atoms and optionally having a substituent, an acyl group having 6 to 20 carbon atoms and optionally having a substituent, a halogen atom, a hydroxy group, a sulfo group, a nitro group, or a carboxyl group; a = 0 or 1; n = 2a + 5; and * denotes a bond to another atom.
[3] The composition for forming a silicon-containing resist film according to [1] or [2], wherein the polysiloxane comprises a thermally crosslinkable polysiloxane comprising at least one of any of a repeating unit represented by formula (Sx-1), a repeating unit represented by formula (Sx-2), or a substructure represented by formula (Sx-3): 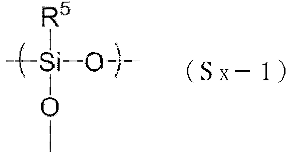 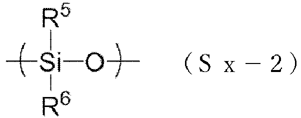 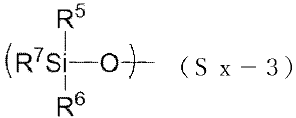 wherein R⁵, R⁶, and R⁷ are each independently a monovalent organic group having 1 to 30 carbon atoms and optionally having a substituent.
[4] The composition for forming a silicon-containing resist film according to any one of [1] to [3], further comprising a crosslinking catalyst.
[5] The composition for forming a silicon-containing resist film according to any one of [1] to [4], wherein the crosslinking catalyst is an ammonium salt or a sulfonium salt.
[6] The composition for forming a silicon-containing resist film according to any one of [1] to [5], further comprising an acid generator.
[7] The composition for forming a silicon-containing resist film according to [6], wherein the acid generator is a sulfonium salt.
[8] A patterning process comprising the steps of:
   forming, on a body to be processed, an organic film using a coating-type organic film material;
   forming, on the organic film, a silicon-containing resist middle layer film using the composition for forming a silicon-containing resist film according to any one of any one of [1] to [7];
   forming, on the silicon-containing resist middle layer film, a resist upper layer film by using a resist upper layer film material comprising a photoresist composition;
   forming a circuit pattern on the resist upper layer film;
   using, as a mask, the resist upper layer film having the formed circuit pattern to transfer the pattern onto the silicon-containing resist middle layer film by etching;
   using, as a mask, the silicon-containing resist middle layer film having the transferred pattern to transfer the pattern onto the organic film by etching; and
   using, as a mask, the organic film having the transferred pattern to transfer the pattern onto the body to be processed by etching.
[9] A patterning process comprising the steps of:
   forming, on a body to be processed by CVD method, a hard mask primarily composed of carbon;
   forming, on the hard mask, a silicon-containing resist middle layer film using the composition for forming a silicon-containing resist film according to any one of any one of [1] to [7];
   forming, on the silicon-containing resist middle layer film, a resist upper layer film by using a resist upper layer film material comprising a photoresist composition;
   forming a circuit pattern on the resist upper layer film;
   using, as a mask, the resist upper layer film having the formed circuit pattern to transfer the pattern onto the silicon-containing resist middle layer film by etching;
   using, as a mask, the silicon-containing resist middle layer film having the transferred pattern to transfer the pattern onto the hard mask by dry etching; and
   using, as a mask, the hard mask having the transferred pattern to transfer the pattern onto the body to be processed by dry etching.
[10] The patterning process according to claim [8], wherein the pattern formation in the step of forming a circuit pattern on the resist upper layer film is pattern formation performed by optical lithography with a wavelength of 10 nm or more and 300 nm or less, direct electron beam lithography, nanoimprinting, or a combination thereof.
[11] The patterning process according to [8], wherein the body to be processed is any of a semiconductor device substrate, a metal film, a metal carbide film, a metal oxide film, a metal nitride film, a metal oxide carbide film, or a metal oxide nitride film.
[12] The patterning process according to [11], wherein a metal constituting the body to be processed is silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A composition for forming a silicon-containing resist film comprising a polysiloxane comprising at least one of any of a repeating unit represented by formula (A-1), a repeating unit represented by formula (A-2), or a substructure represented by formula (A-3): 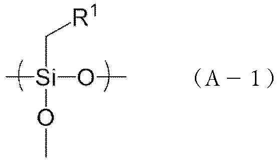 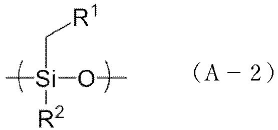 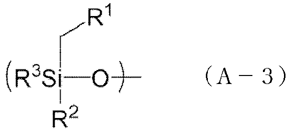 wherein R¹ is a monovalent organic group having 1 to 30 carbon atoms and optionally having a substituent, a halogen atom, a hydroxy group, a sulfo group, a nitro group, or a carboxyl group, functioning as a group eliminated by heat, acid, or base, and R² and R³ each independently represent a monovalent organic group having 1 to 30 carbon atoms and optionally having a substituent.

2. The composition for forming a silicon-containing resist film according to claim 1, wherein R¹ in the formula (A-1), (A-2), or (A-3) is a monovalent group represented by formula (B-1), a halogen atom, a hydroxy group, a sulfo group, a nitro group, or a carboxyl group, functioning as a group eliminated by heat, acid, or base, 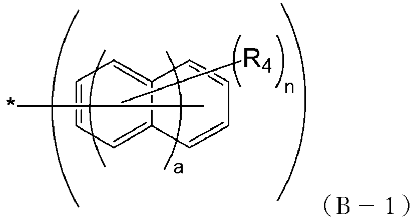 wherein R⁴ are each a substituent attached to an aromatic ring and each independently represent a hydrogen atom or an alkyl group having 1 to 20 carbon atoms and optionally having a substituent, an aryl group having 6 to 20 carbon atoms and optionally having a substituent, a halogenated alkyl group having 1 to 20 carbon atoms and optionally having a substituent, a halogenated aryl group having 6 to 20 carbon atoms and optionally having a substituent, an alkoxyalkyl group having 1 to 20 carbon atoms and optionally having a substituent, an alkoxyaryl group having 6 to 20 carbon atoms and optionally having a substituent, an acyl group having 6 to 20 carbon atoms and optionally having a substituent, a halogen atom, a hydroxy group, a sulfo group, a nitro group, or a carboxyl group; a = 0 or 1; n = 2a + 5; and * denotes a bond to another atom.

3. The composition for forming a silicon-containing resist film according to claim 1 or 2, wherein the polysiloxane comprises a thermally crosslinkable polysiloxane comprising at least one of any of a repeating unit represented by formula (Sx-1), a repeating unit represented by formula (Sx-2), or a substructure represented by formula (Sx-3): 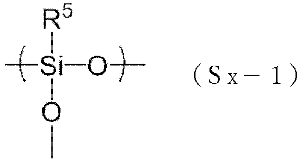 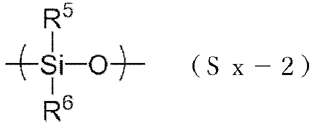 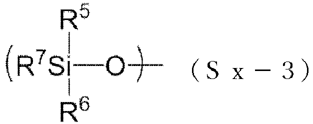 wherein R⁵, R⁶, and R⁷ are each independently a monovalent organic group having 1 to 30 carbon atoms and optionally having a substituent.

4. The composition for forming a silicon-containing resist film according to any one of claims 1 to 3, further comprising a crosslinking catalyst.

5. The composition for forming a silicon-containing resist film according to claim 4, wherein the crosslinking catalyst is an ammonium salt or a sulfonium salt.

6. The composition for forming a silicon-containing resist film according to any one of claims 1 to 5, further comprising an acid generator.

7. The composition for forming a silicon-containing resist film according to claim 6, wherein the acid generator is a sulfonium salt.

8. A patterning process comprising the steps of:
forming, on a body to be processed, an organic film using a coating-type organic film material;
forming, on the organic film, a silicon-containing resist middle layer film using the composition for forming a silicon-containing resist film according to any one of claims 1 to 7;
forming, on the silicon-containing resist middle layer film, a resist upper layer film by using a resist upper layer film material comprising a photoresist composition;
forming a circuit pattern on the resist upper layer film;
using, as a mask, the resist upper layer film having the formed circuit pattern to transfer the pattern onto the silicon-containing resist middle layer film by etching;
using, as a mask, the silicon-containing resist middle layer film having the transferred pattern to transfer the pattern onto the organic film by etching; and
using, as a mask, the organic film having the transferred pattern to transfer the pattern onto the body to be processed by etching.

9. A patterning process comprising the steps of:
forming, on a body to be processed by CVD method, a hard mask primarily composed of carbon;
forming, on the hard mask, a silicon-containing resist middle layer film using the composition for forming a silicon-containing resist film according to any one of claims 1 to 7;
forming, on the silicon-containing resist middle layer film, a resist upper layer film by using a resist upper layer film material comprising a photoresist composition;
forming a circuit pattern on the resist upper layer film;
using, as a mask, the resist upper layer film having the formed circuit pattern to transfer the pattern onto the silicon-containing resist middle layer film by etching;
using, as a mask, the silicon-containing resist middle layer film having the transferred pattern to transfer the pattern onto the hard mask by dry etching; and
using, as a mask, the hard mask having the transferred pattern to transfer the pattern onto the body to be processed by dry etching.

10. The patterning process according to claim 8, wherein the pattern formation in the step of forming a circuit pattern on the resist upper layer film is pattern formation performed by optical lithography with a wavelength of 10 nm or more and 300 nm or less, direct electron beam lithography, nanoimprinting, or a combination thereof.

11. The patterning process according to claim 8, wherein the body to be processed is any of a semiconductor device substrate, a metal film, a metal carbide film, a metal oxide film, a metal nitride film, a metal oxide carbide film, or a metal oxide nitride film.

12. The patterning process according to claim 11,
wherein a metal constituting the body to be processed is silicon, gallium, titanium, tungsten, hafnium, zirconium, chromium, germanium, copper, silver, gold, indium, arsenic, palladium, tantalum, iridium, aluminum, iron, molybdenum, cobalt, or an alloy thereof.
